# EUROPÄISCHE PATENTSCHRIFT

(11) **EP 0 256 986 B1**
(45) Veröffentlichungstag und Bekanntmachung des Hinweises auf die Patenterteilung: **27.04.1994**
(21) Anmeldenummer: 87810456.1
(22) Anmeldetag: 10.08.1987
(51) Int. Cl.: G03F 7/027, G03F 7/16

(54) **Verfahren zur Herstellung von Abbildungen**
Process for obtaining images
Procédé pour obtenir des images

(30) Priorität: 16.08.1986 GB 8620001
(43) Veröffentlichungstag der Anmeldung: 24.02.1988
(73) Patentinhaber: CIBA-GEIGY AG, 4002 Basel (CH)
(72) Erfinder: Irving, Edward, Dr., Burwell Cambridge CB5 0AN (GB); Smith, Terence James, Royston Hertfordshire SG8 6EL (GB)
(74) Vertreter: Sharman, Thomas

(56) Entgegenhaltungen:
- EP-A- 0 176 356
- EP-A- 0 177 453
- DE-A- 2 301 075

## Beschreibung

Die vorliegende Anmeldung betrifft ein Verfahren zur Herstellung von Abbildungen und Zusammensetzungen, die in besagtem Verfahren eingesetzt werden können.

Bei herkömmlichen Abbildungsverfahren beschichtet man ein Substrat mit einem negativ arbeitenden Photolack, der ein photopolymerisierbares Material enthält, bestrahlt die Beschichtung durch ein Negativ mit aktinischer Strahlung, so dass die von der Strahlung getroffenen Teile der Beschichtung photopolymerisiert werden und dadurch weniger löslich werden, während die von der Strahlung abgeschirmten Teile im wesentlichen unbeeinflusst bleiben; anschliessend löst man die nicht bestrahlten und daher nicht photopolymerisierten Teile der Beschichtung mit einem geeigneten Lösungsmittel weg, wobei die photopolymerisierten Teile nicht gelöst werden. Diese letzte Stufe ist als Entwicklung bekannt.

Falls es sich bei der mit dem Photolack beschichteten Oberfläche um eine metallische Oberfläche handelt, kann danach die nach dem Entwickeln freigelegte Oberfläche geätzt werden, um beispielsweise eine Druckplatte oder eine gedruckte Schaltung herzustellen. Anschliessend kann die photopolymerisierten Beschichtung entfernt werden; dies erfolgt entweder chemisch, beispielsweise durch Behandlung mit einem Lösungsmittel, oder mechanisch, beispielsweise durch Abbürsten, oder üblicherweise durch eine Kombination beider Verfahren.

In gängigen Abbildungsverfahren werden bereits negativ arbeitende, flüssige Photolacke oder sogenannte Trockenresists ("Dry Film Resists") eingesetzt.

Bei den flüssigen Photolacken handelt es sich in der Regel um Lösungen von filmbildenden, photopolymerisierten Materialien in organischen Lösungsmitteln, wobei das Lösungsmittel nach Aufbringen der Schicht auf das betreffende Substrat verdampfen gelassen wird. Abgesehen von den arbeitshygienischen Problemen, die die Verwendung von organischen Lösungsmitteln mit sich bringt, ist es schwierig, mit flüssigen Photolacken einheitliche Filme herzustellten, die im wesentlichen keine Störungen (Pinholes) aufweisen.

Verwendet man solche flüssigen Photolacke also beispielsweise bei der Herstellung von gedruckten Schaltungen, bei denen metallüberzogene durchgehende Oeffnungen oder Verbindungen vorhanden sind, so treten üblicherweise Probleme, wie Blockierung der Oeffnungen oder schlechte Bedeckung der Ränder besagter Oeffnungen, auf.

Um diese Nachteile flüssiger Photolacke zu umgehen, werden sogenannte Trockenresists verwendet. Solche Photolacke haben aber in der Regel eine schlechte Haftung auf dem Metall, so dass dieses jeweils einer speziellen Vorbehandlung unterzogen werden muss; ausserdem werden auf unregelmässigen Oberflächen in der Regel keine befriedigenden Ergebnisse erzielt.

Ausserdem muss der Trockenresist auf die Grösse der zu beschichtenden Oberfläche zurechtgeschnitten werden, weshalb unter Umständen ein beträchtlicher Anteil des Films nicht verwendet werden kann.

Probleme, die im Zusammenhang mit herkömmlichen, flüssigen Photolacken oder Trockenresists auftreten, können in der Regel umgangen werden, indem man auf elektrisch leitfähigen Oberflächen einen geeigeneten Photolack galvanisch abscheidet. So ist beispielsweise aus der EP-A 176,356 ein Verfahren bekannt, bei dem ein Photolackfilm aus einer wässrigen Lösung oder Emulsion galvanisch abgeschieden wird; diese Lösung oder Emulsion enthält eine Mischung eines positiv oder negativ geladenen Polymeren, ein multifunktionelles Acrylat oder Methacrylat als photovernetzbare Komponente und einen Photoinitiator.

Durch die Verwendung solcher galvanisch abscheidbarer Mischungen können anfänglich Abbildungen guter Qualität erzielt werden. Nachdem eine Reihe von galvanischen Abscheidungsprozessen durchgeführt wurden, kann man mit den Filmen jedoch keine befriedigenden Abbildungen mehr erzielen, sogar dann nicht, wenn man die Belichtungszeit beträchtlich länger wählt als bei den anfänglich erzeugten Filmen.

Darüber hinaus besitzen die aus besagten Mischungen galvanisch abgeschiedenen Filme während der Trocknung durch Erhitzen vor der Belichtung eine Tendenz zum Fliessen, so dass uneinheitliche Photolackfilme entstehen.

Es wurde jetzt gefunden, dass man Abbildungen zur Herstellung von Druckplatten und gedruckten Schaltungen gut reproduzierbar herstellen kann, indem man galvanisch abscheidbare Photolacke verwendet, die eine geringe Neigung zum Fliessen bei der Erhitzungsstufe vor der Belichtung besitzen. Diese Photolacke werden aus einem Galvanisierbad abgeschieden, das ein filmbildendes Harz enthält, das in ein und demselben Molekül strahlungspolymerisierbare Gruppen, mindestens einen die Photopolymerisation dieser Gruppen initiierenden Rest und mindestens eine salzbildende Gruppe enthält.

Die vorliegende Erfindung betrifft eine Verfahren zur Herstellung von Abbildungen auf Substraten mit einer elektrisch leitfähigen Oberfläche umfassend die Schritte
i) Aufbringen einer strahlungspolymerisierbaren Schicht auf besagte Oberfläche durch galvanisches Abscheiden aus einer Zusammensetzung enthaltend eine Lösung oder eine Dispersion eines festen, strahlungspolymerisierbaren Harzes in einem zur galvanischen Abscheidung geeigneten Medium, wobei besagtes Harz in Mittel pro Molekül mehr als eine strahlungspolymerisierbare, ethylenisch ungesättigte Gruppe, einen Photoinitiatorrest, der bei Bestrahlung die Polymerisation besagter strahlungspolymerisierbaren Gruppe initiiert, und eine salzbildende Gruppe, die zumindest teilweise in ionisierter Form vorliegt, enthält,
ii) Bestrahlen besagter Schicht mit einem vorbestimmten Muster aktinischer Strahlung, wobei die bestrahlten Teile der Schicht polymerisieren, und
iii) Entfernen der in Schritt ii) nicht der Strahlung ausgesetzten Teile der Schicht.

Bei strahlungspolymerisierbaren Gruppen im Harz handelt es sich in der Regel um Vinylgruppen, bevorzugt um Acylgruppen, insbesondere um Acrylate und α-substituierte Acrylate, beispielsweise Methacrylatgruppen, oder um Acrylamido- oder Methacrylamidogruppen, wobei die Acrylat- und Methacrylatgruppen besonders bevorzugt werden.

Der Photoinitiatorrest kann in das Polymergerüst eingebaut sein; in diesem Falle ist er mit dem restlichen Molekül über mindestens zwei Bindungen verknüpft. In den meisten Fällen ist der Photoinitiatorrest an das Polymergerüst gebunden, d.h. er ist mit dem Polymermolekül nur über eine Bindung verbunden.

Das strahlungspolymerisierbare Harz kann einen oder mehrere solcher Photoinitiatorreste enthalten.

Photoinitiatorreste, die die Polymerisation von strahlungspolymerisierbaren Gruppen initiieren sind wohlbekannt. Für ethylenisch ungesättigte Reste eignen sich beispielsweise solche photoinitiierenden Gruppen, die freie Radikale zu bilden vermögen. Dies erfolgt beispielsweise durch photolytische Dissoziation oder durch eine Reaktion, üblicherweise eine Wasserstoffübertragung, mit einem weiteren Molekül.

Geeignete Photoinitiatorreste leiten sich beispielsweise ab von Benzophenon, Ketocoumarin, Benzil, Anthrachinon, Phenanthrachinon, α-substituiertem Acetophenon, Acylphosphinoxid, O-acyliertem α-Oximinoketon, Xanthon oder Thioxanthon, wobei besagte Gruppen mit dem Polymergerüst durch eine oder mehrere Bindungen verknüpft sind.

Von diesen Resten sind insbesondere Benzophenon-, α-substituierte Acetophenon- oder Thioxanthonreste bevorzugt.

Die Benzophenonreste sind vorzugsweise mit zwei bis vier Bindungen in das Polymergerüst eingebaut oder sind an das Polymergerüst gebunden.

Die substituierten Acetophenon- und Thioxanthonreste sind vorzugsweise an das Polvmergerüst gebunden.

Besonders bevorzugte strahlungspolymerisierbare Harze enthalten photoinitiierende Reste, die ausgewählt werden aus der Gruppe bestehend aus
a) Benzophenonresten der Formeln IA, IB, IC und ID

   -Ar¹-CO-Ar² (IA),

   -Ar¹-CO-Ar¹- (IB),

   -Ar¹-CO-Ar³〈 (IC),

   〉Ar³-CO-Ar³〈 (ID),
b) α-substituierten Acetophenonresten der Formeln II, III, IV, V oder VI 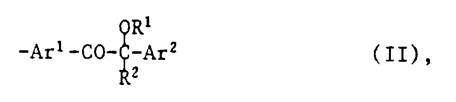 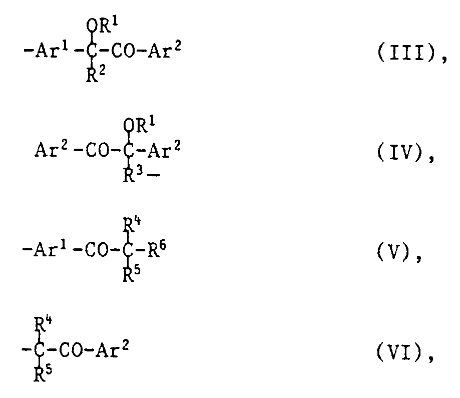 oder
c) Thioxanthonresten der Formel VII 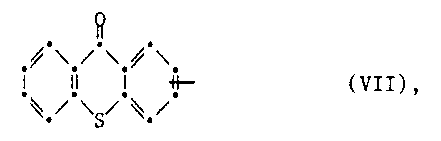 worin der jeweilige photoinitiierende Rest mit dem Restmolekül durch die freie(n) Bindung(en) verbunden ist,
   Ar¹ eine Phenylengruppe ist, die gegebenenfalls mit ein bis drei Resten R⁷ substituiert ist,
   Ar² eine Phenylgruppe ist, die gegebenenfalls mit ein bis drei Resten R⁷ substituiertist,
   Ar³ eine Benzoltriylgruppe ist, die gegebenenfalls mit ein bis drei Resten R⁷ substituiert ist,
   R¹ Wasserstoff oder -CH₂R⁸ ist,
   R² Wasserstoff, -O-CH₂R⁸ oder -CH₂-OR⁸ ist,
   R³ C₁-C₂₀-Alkylen bedeutet, das durch ein oder mehrere Sauerstoffatome unterbrochen sein kann,
   R⁴ und R⁵ unabhängig voneinander Wasserstoff oder eine einwertige aliphatische, cycloaliphatische oder araliphatische Gruppe sind, oder zusammen mit dem gemeinsamen Kohlenstoffatom eine Cycloalkylengruppe darstellen,
   R⁶ eine Hydroxylgruppe, Amino oder eine alkylierte oder silylierte Hydroxyl- oder Aminogruppe ist,
   R⁷ ein Halogenatom, C₁-C₂₀-Alkyl, C₁-C₂₀-Halogenalkyl, C₁-C₂₀-Alkoxy, C₆-C₁₂-Aryloxy, C₂-C₂₀-Acyloxy, C₂-C₂₀-Alkoxycarbonyl, C₇-C₁₃-Aracyloxy, C₂-C₄₀-Dialkylamino, C₁-C₂₀-Alkylthio, C₆-C₁₂-Arylthio oder Cyan bedeutet,
   R⁸ Wasserstoff, Hydroxyl, C₁-C₈-Alkyl, C₁-C₄-Alkoxy, C₂-C₃-Alkenyl, C₇-C₉-Aralkyl, C₈-C₉-Aralkenyl oder -(CH₂)ₐR⁹ bedeutet,
   a 1, 2 oder 3 ist und
   R⁹ ein Halogenatom, Hydroxyl, C₁-C₄-Alkoxy, C₁-C₄-Alkylthio, Phenoxy, Phenylthio, C₂-C₈-Acyloxy, C₇-C₁₂-Aracyloxy oder C₂-C₈-Alkoxycarbonyl ist.

Der Begriff "alkylierte Aminogruppe", so wie er in der Definition von R⁶ verwendet wird, umfasst Reste, in denen eines oder beide Wasserstoffatome der Aminogruppe durch gegebenenfalls substituierte Alkylgruppen ersetzt sind, sowie Reste, in denen beide Aminowasserstoffatome durch eine ein Stickstoff- oder Sauerstoffatom enthaltende Alkylenkette ersetzt sind, so dass zusammen mit dem Aminostickstoff eine heterocyclische Gruppe entsteht.

In den Formeln IA bis VI ist Ar¹ vorzugsweise eine unsubstituierte oder durch einen Rest R⁷ substituierte Phenylengruppe, ganz besonders bevorzugt jedoch eine unsubstituierte Phenylengruppe;
Ar² ist vorzugsweise eine unsubstituierte oder durch einen Rest R⁷ substituierte Phenylgruppe, insbesondere eine unsubstituierte Phenylgruppe;
Ar³ ist vorzugsweise eine unsubstituierte oder durch einen Rest R⁷ substituierte Benzoltriylgruppe, insbesondere eine unsubstituierte Benzoltriylgruppe;
R¹ ist vorzugsweise Wasserstoff oder ein Rest -CH₂R⁸;
R² ist vorzugsweise Wasserstoff, -O-CH₂R⁸ oder -CH₂-OR⁸;
R³ ist vorzugsweise C₁-C₁₀-Alkylen, insbesondere Methylen, Ethylen oder 1,2-Propylen;
R⁴ und R⁵ sind vorzugsweise Wasserstoff, C₁-C₈-Alkyl bilden zusammen mit dem gemeinsamen Kohlenstoffatom eine Cyclohexylengruppe; insbesondere handelt es sich bei diesen Resten um Methyl, Ethyl oder zusammen mit dem gemeinsamen Kohlenstoffatom um Cyclohexylen;
R⁶ ist vorzugsweise -N(R¹⁰)R¹¹, worin R¹⁰ und R¹¹ gleiche oder unterschiedliche Bedeutungen besitzen können und C₁-C₄-Alkyl, das gegebenenfalls durch eine Hydroxylgruppe substituiert ist, bedeuten, oder R¹⁰ und R¹¹ zusammen mit dem gemeinsamen Stockstoffatom einen heterocyclischen Ring mit vier oder fünf Kohlenstoffatomen bilden, der gegebenenfalls ein weiteres Sauerstoff- oder Stickstoffatom enthalten kann; R⁶ ist ganz besonders bevorzugt eine N,N-Di-(hydroxyethyl)-aminogruppe oder eine N-Piperidinogruppe oder eine N-Morpholinogruppe;
R⁷ ist vorzugsweise ein Halogenatom, C₁-C₁₀-Alkyl, C₂-C₈-Dialkylamino, C₁-C₄-Alkoxy oder C₁-C₄-Alkylthio; ganz besonders bevorzugt ist R⁷ ein Chlor- oder Bromatom, Methyl, Isopropyl, tert.Butyl, Methoxy oder Methylthio;
R⁸ ist vorzugsweise Wasserstoff, Hydroxyl, C₁-C₄-Alkyl, C₁-C₄-Alkoxy oder -(CH₂)ₐR⁹, insbesondere ein Wasserstoffatom, Hydroxyl oder Methoxy;
R⁹ ist vorzugsweise Hydroxyl, C₁-C₄-Alkoxy oder C₁-C₄-Alkylthio, insbesondere Methoxy oder Methylthio;
der Index a ist insbesondere 1 oder 2, ganz besonders bevorzugt jedoch 1.

Die Gruppen der Formeln I bis VII können an das restliche Polymermolekül über eine beliebige Brückengruppe gebunden sein; diese Brückengruppe leitet sich von einer reaktiven Gruppe ab, die an besagter Gruppe der Formel I bis VII befestigt ist.

Geeignete Brückengruppen sind beispielsweise die Reste der Formeln -O-, -OCO-, -OSO₂-, -OCH₂-, -OCH₂CH(OH)CH₂-, -OCONH-, -O(CH₂-CR¹²)_{b}O-, -O(CH₂-CR¹²)_{b})OCO-, -O(CH₂-CR¹²)_{b}OSO₂-, -O(CH₂-CR¹²)_{b}OCH₂-, -O(CH₂-CR¹²)_{b})OCONH-, -COO-, -COS-, -COOCH₂CH(OH)CH₂-, -CONH-, -SO₂O-, -SO₂S-, -CH₂-, -CH₂O-, -CH₂S-, -NHCOO-, -NHCO-, -NHCOS-, -P(=O)(OR¹³)O-, -P(=O)(OR¹³)OCH₂CH(OH)CH₂-, -SCH₂CH(OH)CH₂-, -SCONH-, -SCO-, -SSO₂-, -SCH₂-, -S(CH₂CR¹²)_{b}O-, -S(CH₂CR¹²)_{b}OCO-, -S(CH₂CR¹²)_{b}OSO₂-, -S(CH₂CR¹²)_{b}OCH₂- oder -S(CH₂CR¹²)_{b}OCONH-, worin die linke freie Valenz jeder dieser Gruppen der freien Valenz in den Gruppen der Formeln I bis VII entspricht, R¹² Wasserstoff oder Methyl bedeutet, R¹³ C₁-C₄-Alkyl ist und b 1 bis 4 ist.

Unter den oben aufgezählten Brückengruppen sind insbesondere die Reste -O-, -OCO-, -OCH₂CH(OH)CH₂-, -COO-, -COOCH₂CH(OH)CH₂-, -P(=O)(OCH₂CH₃)O-, -P(=O)(OCH₂CH₃)OCH₂CH(OH)CH₂- und -SCH₂CH₂OCO-bevorzugt.

In einer ganz besonders bevorzugten Ausführungsform enthalten die strahlungspolymerisierbaren Harze einen photoinitiierender Rest der Formel ID, worin Ar³ ein unsubstituierter Benzoltriylrest ist.

Zu einer zweiten bevorzugten Gruppe von strahlungspolymerisierbaren Harzen zählen Verbindungen, worin ein photoinitiierender Rest der Formel IV enthalten ist, worin R¹ Wasserstoff bedeutet und R³ eine Methylengruppe darstellt.

Eine weitere bevorzugte Klasse von strahlungspolymerisierbaren Polymeren betrifft Verbindungen, worin ein photoinitiierender Rest der Formel enthalten ist, worin R⁴ und R⁵ Methyl sind und R⁶ eine N-Morpholinogruppe darstellt.

Weitere bevorzugte strahlungspolymerisierbare Harze enthalten den photoinitiierender Rest der Formel VI, worin R⁴ und R⁵ zusammen mit dem gemeinsamen Kohlenstoffatom eine Cyclohexylengruppe bilden.

Bei der salzbildenden Gruppe in dem strahlungspolymerisierbaren Harz kann es sich um eine saure Gruppe, beispielsweise um eine Carbonsäure- oder Sulfonsäuregruppe, handeln oder es ist eine basische Gruppe, beispielsweise eine sekundäre oder tertiäre Aminogruppe oder eine quaternäre Ammoniumgruppe.
Geeignete Harze mit photopolymerisierbaren, ethylenisch ungesättigten Resten, photoinitiierenden Resten und salzbildenden Gruppen, wie oben definiert, sind beispielsweise erhältlich durch Umsetzung von
A) einer Verbindung mit wenigstens eine strahlungspolymerisierbaren Gruppe und wenigstens einer reaktiven funktionellen Gruppe X mit
B) einer Verbindung enthaltend besagten photoinitiierenden Rest und wenigstens eine Gruppe Y, die mit dem Rest X reagiert, oder durch Umsetzung eines Reaktionsproduktes von A) und B) mit wenigstens einer weiteren Verbindung C), um das Molekulargewicht zu erhöhen, wobei die salzbildende Gruppe in den Ausgangsprodukten A), B) oder
C) vorhanden sein kann oder in das Reaktionsprodukt von A) und B) oder in dessen Umsetzungsprodukt mit C) eingeführt werden kann. Die Reaktanden A) und B), deren Mengenverhältnisse und die Reaktionsbedingungen können in der Weise gewählt werden, so dass feste, filmbildende Harze, wie beschrieben, entstehen; oder ein Umsetzungsprodukt von A) und B) kann auch mit einer weiteren Verbindung umgesetzt werden, um das Molekulargewicht zu erhöhen, so dass aus einem flüssigen Reaktionsprodukt aus A) und B) ein festes, filmbildendes Harz entsteht.

Enthält beispielsweise das Reaktionsprodukt von A) und B) im Mittel mehr als eine primäre oder sekundäre Hydroxylgruppe im Molekül, so kann es in einer Polykondensationsstufe mit einer Verbindung enthaltend wenigstens zwei Acylhalogenidgruppen umgesetzt werden oder es kann in einer Polyadditionsstufe mit einer Verbindung enthaltend wenigstens zwei Isocyanatgruppen oder Carbonsäureanhydridgruppen umgesetzt werden.

Bei dieser Zusatzreaktion zur Vergrösserung des Molekulargewichts kann auch die salzbildende Umsetzung von Hydroxylgruppen mit der Anhydridfunktion, wobei Carboxylgruppen eingeführt werden.

Die weitere Umsetzung kann aber auch verwendet werden, um Harze mit zwei oder mehreren strahlungspolymerisierbaren Gruppen herzustellen, beispielsweise aus Umsetzungsprodukten aus A) und B), die im Mittel nur einen solchen Rest aufweisen, wobei zwei oder mehrere solcher Umsetzungsprodukte miteinander verknüpft werden.

Besitzt A) mehr als eine Gruppe X und B) mehr als eine Gruppe Y, beispielsweise wenn A) ein Diepoxid ist und B) ein zweiwertiges Phenol ist, so kann das Umsetzungsprodukt ein Harz sein, das den photoinitiierenden Rest in das Molekülgerüst eingebaut enthält.

Wie bereits weiter oben beschrieben sind, jedoch bei den meisten Klassen von bevorzugten strahlungspolymerisierbaren Harzen enthaltend photoinitiierende Reste besagte photoinitiierende Reste an das Polymergerüst gebunden. Bei solchen Harzen handelt es sich also vorzugsweise um Umsetzungsprodukte von A) und B), die durch Reaktion von einem Rest X mit einem Rest Y erhältlich sind und die gegebenenfalls mit einer weiteren Verbindung C) umgesetzt werden, wie oben beschrieben. Geeignete Kombinationen von reaktiven Gruppen X und Y sind dem Fachmann auf dem Gebiet der Herstellung strahlungspolymerisierbarer Harze bekannt.

Geeignete Reaktanden A) und B) umfassen beispielsweise Verbindungen, worin X eine Hydroxylgruppe ist und Y eine Carboxyl-, veresterte Carboxyl-, Halocarbonyl-, Anhydrid-, Sulfonsäure-, Phosphonsäure-, Halosulfonyl-, Halophosphonyl-, Halomethyl-, Epoxid- oder Isocyanatgruppe ist; oder worin X eine Carboxyl- oder Phosphonsäuregruppe ist und Y eine Hydroxyl-, Merkapto-, Epoxid-, sekundäre Amino-oder Isocyanatgruppe bedeutet; oder worin X eine Halocarbonyl-, Halosulfonyl-, Halomethyl-, veresterte Carboxyl- oder Anhydridgruppe ist und Y eine Hydroxyl-, Merkapto-, sekundäre Amino- oder Epoxidgruppe bedeutet; oder X eine Epoxidgruppe ist und Y eine Hydroxyl-, Carboxyl-, Anhydrid-, Phosphonsäure-, sekundäre Amino- oder Merkaptogruppe bedeutet; oder worin X eine Isocyanatgruppe ist und Y eine Hydroxyl-, Carboxyl-, Merkapto-, Halomethyl- oder sekundäre Aminogruppe bedeutet; oder worin X eine sekundäre Aminogruppe ist und Y eine Halocarbonyl-, Halosulfonyl-, Carboxyl-, veresterte Carboxyl-, Anhydrid-, Halomethyl- oder Isocyanatgruppe ist; oder worin X eine Merkaptogruppe ist und Y eine Epoxid-, Isocyanat-, Carboxyl-, veresterte Carboxyl-, Halocarbonyl-, Halosulfonyl-, Halomethyl- oder Anhydridgruppe bedeutet.

Bevorzugte Umsetzungsprodukte von A) und B) sind diejenigen Verbindungen, worin A) eine Verbindung ist, die wenigstens einen strahlungspolymerisierbaren, ethylenisch ungesättigten Rest aufweist, und B) eine Verbindung ist, die einen photoinitiierenden Benzophenon-, α-substituierten Acetophenon- oder Thioxanthonrest aufweist, wobei eine der Verbindungen A) und B) eine Epoxidgruppe enthält und die andere eine Hydroxyl-, Carboxyl-, Carbonsäureanhydrid- oder Phosphonsäuregruppe enthält.

Diese bevorzugten Umsetzungsprodukte von A) und B) enthalten sekundäre Hydroxylgruppen und können weiter mit C) einem Dianhydrid einer Polycarbonsäure umgesetzt werden, um das Molekulargewicht zu vergrössern und/oder eine salzbildende Gruppe einzuführen; oder diese Umsetzungsprodukte von A) und B) können weiter mit einem Diisocyanat umgesetzt werden, um das Molekulargewicht zu vergrössern.

Handelt es sich bei den Umsetzungsprodukten von A) und B) um Verbindungen mit einem ausreichenden Molekulargewicht, so kann man diese auch anderen Reaktionen unterwerfen, beispielsweise mit einem Monoanhydrid einer Polycarbonsäure umsetzen, um die salzbildende Gruppe einzuführen; dies wird beispielsweise dann der Fall sein, wenn das Umsetzungsprodukt von A) und B) keine salzbildende Gruppe enthält oder wenn weitere salzbildende Gruppen eingeführt werden sollen.

Die vorliegende Erfindung betrifft also zusätzlich ein festes, strahlungspolymerisierbares Harz, das sich zur Durchführung des oben definierten Verfahrens eignet, wobei besagtes Harz ein Umsetzungsprodukt ist von A) einer Verbindung enthaltend wenigstens einen strahlungspolymerisierbaren, ethylenisch ungesättigten Rest mit B) einer Verbindung enthaltend einen photoinitiierende Benzophenon-, α-substituierten Acetophenon- oder Thioxanthonrest, wobei eine der Verbindungen A) und B) eine Epoxidgruppe enthält und die andere eine Hydroxyl-, Carboxyl- oder Phosphonsäuregruppe enthält, und wobei besagtes Umsetzungsprodukt gegebenenfalls zur Erhöhung des Molekulargewichts mit einer weiteren Verbindung C) modifiziert wird, wobei besagtes Umsetzungsprodukt eine salzbildende Gruppe enthält, die sich ableitet von A), B) oder C) oder die nachträglich durch eine weitere Reaktion in das Molekül eingeführt wird.

Zu einer besonders bevorzugten Gruppe von Umsetzungprodukten von A) und B) zählen Verbindungen, worin A) sich ableitet von einer Verbindung A1) enthaltend wenigstens eine strahlungspolymerisierbare, ethylenisch ungesättigte Gruppe und wenigstens eine Hydroxyl-, Carboxyl- oder Phosphonsäuregruppe und B) sich ableitet von einer Verbindung B1) enthaltend einen photoinitiierenden Benzophenon-, α-substituierten Acetophenon- oder Thioxanthonrest und wenigstens eine Epoxidgruppe.

Zu den besonders geeigneten Verbindungen B1) zählen Glycidylether und Glycidylester, die durch herkömmliche Glycidylisierung von Verbindung enthaltend einen photoinitiierenden Rest des oben definierten Typs und eine Hydroxyl-, Carboxyl- oder Phosphonsäuregruppe erhalten werden.

Bevorzugte Verbindungen B1) sind Umsetzungsprodukte von Epoxidharzen, mit einer mittleren Anzahl von mehr als einer Epoxidgruppe pro Molekül, mit weniger als der stöchiometrischen Menge einer Verbindung enthaltend besagten photoiniierenden Rest und besagte Hydroxyl-, Carboxyl-, oder Phosphonsäuregruppe.

Ganz besonders bevorzugte Verbindungen B1) für besagte Umsetzungen sind Umsetzungsprodukte eines Epoxidharzes mit weniger als der stöchiometrischen Menge eines Benzophenons ausgewählt aus der Gruppe der Verbindungen der Formeln VIIIA, VIIIB oder VIIIC

Y¹-Ar¹-CO-Ar² (VIIIA),

Y¹-Ar¹-CO-Ar¹-Y¹ (VIIIB),

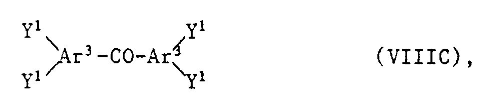

oder eines α-substituierten Acetophenons ausgewählt aus der Gruppe der Verbindungen der Formeln IX, X oder XI 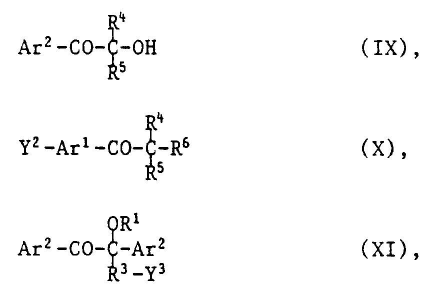
oder eines Thioxantons der Formel XII 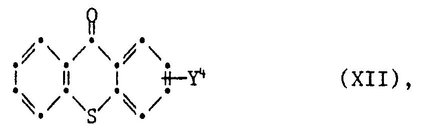
worin Ar¹, Ar², Ar³, R¹, R³, R⁴, R⁵ und R⁶ die oben definierten Bedeutungen besitzen,
Y¹ -OH oder -COOH ist,
Y² eine der für Y¹ definierten Bedeutungen besitzt oder -S-CH₂-CH₂-OH ist,
Y³ eine der für Y¹ definierten Bedeutungen besitzt oder -P(=O)(O-CH₂-CH₃)(OH) ist,
Y⁴ eine der für Y¹ definierten Bedeutungen besitzt oder -O-CH₂-CH(OH)-CH₂-N(R¹⁴)R¹⁵ ist und R¹⁴ und R¹⁵ unabhängig voneinander C₁-C₂₀-Alkyl, das gegebenenfalls durch eine Hydroxylgruppe substituiert ist, oder R¹⁴ und R¹⁵ zusammen mit dem gemeinsamen Stickstoffatom einen heterocyclischen Ring enthaltend drei bis fünf Kohlenstoffatome und gegebenenfalls ein Sauerstoffatom oder ein Schwefelatom oder ein zusätzliches Stickstoffatom, bilden.

Besonders bevorzugte Vertreter von Verbindungen der Formeln VIIIA bis XII sind Verbindungen der Formel VIIIA, worin Ar¹ eine unsubstituierte Phenylengruppe ist, Y¹ eine Hydroxyl- oder Carboxylgruppe bedeutet, die sich in ortho-, meta- oder para-Position zur Carbonylgruppe befindet, und Ar² eine unsubstituierte Phenylgruppe ist; ebenfalls bevorzugt sind Verbindungen der Formel VIIIC, worin Ar³ eine unsubstituierte Benzoltriylgruppe ist und jedes Y¹ eine Carbonsäuregruppe bedeutet; ferner werden Verbindungen der Formel IX bevorzugt, worin Ar² eine unsubstituierte oder 4-isopropyl- oder 4-tert.-butyl-substituierte Phenylgruppe ist und R⁴ und R⁵ unabhängig voneinander Wasserstoff oder C₁-C₈-Alkyl bedeuten oder zsuammen mit dem gemeinsamen Kohlenstoffatom eine Cyclohexylengruppe bilden; weiter werden Verbidungen der Formel X bevorzugt, worin Ar¹ eine substituierte Phenylengruppe ist, Y² eine Gruppe der Formel -S-CH₂-CH₂-OH bedeutet, R⁴ und R⁵ unabhängig voneinander C₁-C₈-Alkyl sind oder zusammen mit dem gemeinsamen Kohlenstoffatom eine Cyclohexylengruppe bilden und R⁶ eine Gruppe der Formel -N(R¹⁰)R¹¹ ist, worin R¹⁰ und R¹¹ die weiter oben definierte Bedeutung besitzen; ferner werden Verbindungen der Formel XI bevorzugt, worin AR² eine unsubstituierte Phenylgruppe ist, R¹ Wasserstoff oder -CH₂-R⁸ bedeutet, R⁸ die weiter oben definierte Bedeutung besitzt, R³ C₁-C₁₀-Alkylen ist und Y³ eine Hydroxyl- oder Carboxylgruppe ist oder eine Gruppe der Formel -P(O)(OCH₂CH₃)(OH) ist; ferner werden Verbindungen der Formel XII bevorzugt, worin Y⁴ eine Hydroxyl- oder Carboxylgruppe ist oder eine Gruppe der Formel -O-CH₂-CH(OH)-CH₂-N(R¹⁶)¹⁷ ist, worin R¹⁶ und R¹⁷ unabhängig voneinander C₁-C₈-Alkyl sind, das gegebenenfalls durch eine Hydroxylgruppe substituiert ist, wobei jede der angegebenen Gruppen in 1-, 2-, 3- oder 4-Position des Thioxanthonringes stehen kann.

Ganz besonders bevorzugte Verbindungen der Formeln VIIIA bis XII sind Verbindungen der Formel VIIIA, worin Ar¹ eine unsubstituierte Phenylengruppe ist, Y¹ eine Hydroxyl- oder Carboxylgruppe darstellt, die sich in ortho-Position zur angegebenen Carbonylgruppe befindet und Ar² eine unsubstituierte Phenylgruppe ist; oder Verbindungen der Formel VIIIC, worin Ar³ eine unsubstituierte Benzoltriylgruppe ist und die Reste Y¹ Carbonylgruppen darstellen, die sich in para- oder meta-Position zur angegebenen Carbonylgruppen befinden; oder Verbindungen der Formel IX, worin Ar² eine unsubstituierte Phenylgruppe ist und R⁴ und R⁵ jeweils eine Methyl- oder Ethylgruppe bedeuten oder, zusammen mit dem gemeinsamen Kohlenstoffatom, eine Cyclohexylengruppe darstellen; oder Verbindungen der Formel X, worin Ar¹ eine unsubstituierte Phenylengruppe ist, Y² eine Gruppe der Formel -S-CH₂-CH₂-OH ist, R⁴ und R⁵ jeweils eine Methyl- oder Ethylgruppe darstellen oder zusammen mit dem gemeinsamen Kohlenstoffatom eine Cyclohexylengruppe sind R⁶ eine N,N-Di-(hydroxyethyl)-aminogruppe, eine N-Piperidyl- oder eine N-Morpholinogruppe sind; oder Verbindungen der Formel XI, worin Ar² eine unsubstituierte Phenylgruppe ist, R¹ Methyl bedeutet, R³ -CH₂-CH₂- oder -CH₂-CH(CH₃)- darstellt und Y³ eine Carboxylgruppe oder eine Gruppe der Formel -P(O)(OCH₂CH₃)(OH) ist; oder Verbindungen der Formel XII, worin Y⁴ eine Hydroxyl- oder Carboxylgruppe ist oder eine Gruppe der Formel -O-CH₂-CH(OH)-CH₂-N(CH₃)₂ in 2-Position des Thioxanthonringes bedeutet.

Ganz besonders bevorzugte Verbindungen der Formeln VIIIA bis XII sind o-Benzoylbenzoesäure, α-Methylolbenzoin, also eine Verbindung der Formel XI, worin Ar² eine unsubstituierte Phenylgruppe ist, R¹ Wasserstoff bedeutet, R³ eine Methylengruppe ist und Y³ eine Hydroxylgruppe ist; α,α-Dimethyl-α-N-morpholino-p-(2-hydroxyethylthio)-acetophenon, also eine Verbindung der Formel X, worin Ar¹ eine unsubstituierte Phenylgruppe ist, Y² eine Gruppe der Formel -S-CH₂-CH₂-OH ist, R⁴ und R⁵ je Methyl bedeuten und R⁶ eine N-Morpholinogruppe ist; oder 1-Benzoylcyclohexanol, also eine Verbindung der Formel IX, worin Ar² eine unsubstituierte Phenylgruppe ist und R⁴ und R⁵ zusammen mit dem gemeinsamen Kohlenstoffatom eine Cyclohexylengruppe darstellen.

Die Verbindungen der Formeln VIIIA bis XII sind entweder kommerziell erhältlich oder sie können mittels Routineverfahren aus kommerziell erhältlichen Ausgangsmaterialien erhalten werden.

So kann man beispielsweise viele der Benzophenone der Formeln VIIIA bis VIIIC käuflich erwerben und die nicht erhältlichen Typen können mittels Standardmethoden der Herstellung von hydroxyl- oder carboxylsubstituierten aromatischen Verbindungen erhalten werden.

Verbindungen der Formel IX, worin R⁴ und R⁵ je Methyl sind und Ar² Phenyl, 4-Isopropylphenyl oder 4-tert.Butylphenyl bedeuten, sowie 1-Benzoylcyclohexanol sind kommerziell erhältlich.

Weitere Verbindungen der Formel IX und der Formel X können beispielsweise durch Bromierung von α-substituierten Acetophenonen der Formel Ar-CO-CH(R⁴)R⁵, worin Ar für Ar² oder Y²-Ar¹- steht und Ar¹, Ar², R⁴ und R⁵ die weiter oben definierten Bedeutungen besitzen, hergestellt werden; dabei entsteht eine bromierte Verbindung der Formel Ar-CO-CBr(R⁴)R⁵. Diese kann dann weiter mit Natriumethanolat umgesetzt werden, wobei ein Oxiran gebildet wird; der Oxiranring kann dann anschliessend geöffnet werden, wobei man die Verbindung entweder mit einer Säure (zur Herstellung von Verbindungen der Formel IX oder der Formel X, worin R⁶ eine Hydroxylgruppe oder eine silylierte Hydroxylgruppe bedeutet) oder mit einem Amin (zur Herstellung von Verbindungen der Formel X, worin R⁶ eine Aminogruppe darstellt, die gegebenenfalls alkyliert oder silyliert ist) umsetzt.

Verbindungen der Formel XI lassen sich beispielsweise erhalten, indem man einen Benzoinalkylether der Formel Ar²-CO-CH(OR¹)-Ar², worin Ar² und R¹ die weiter oben definierte Bedeutung besitzen, mit Formaldehyd oder Glyoxylsäure umsetzt, oder damit eine Michael Additionsreaktion durchführt mit einer Verbindung der Formel R¹⁸Y^{a}, worin R¹⁸ eine C₂-C₂₀-Alkenylgruppe ist, die gegebenenfalls durch Sauerstoff unterbrochen sein kann, und Y^{a} eine Gruppe Y³ oder ein Vorläufer besagter Gruppe ist, beispielsweise eine versterte Hydroxyl- oder Carboxylgruppe.

Die Verbindungen der Formel XII, worin Y⁴ eine Hydroxylgruppe in 2-, 3- oder 4-Position ist, sind kommerziell erhältlich und können bei der Herstellung von Verbindungen eingesetzt werden, worin Y⁴ -CH₂-CH(OH)-CH₂-N(R¹⁴)R¹⁵ bedeutet; dabei glycidylisiert man die Hydroxylgruppe besagter Verbindungen und setzt die Glycidylgruppe dann mit einem Amin der Formel HN(R¹⁴)R¹⁵ um.

In dieser bevorzugten Gruppe von Reaktionsprodukten von A) und B) ist die ethylenisch ungesättigte Gruppe A1) vorzugsweise eine Vinylgruppe, insbesondere eine Acrylgruppe, wie beispielsweise eine Acrylat-, Methacrylat-, Acrylamido- oder Methyacrylamidogruppe.

Bevorzugte Verbindungen A1) sind Acrylsäure, Methacrylsäure und Addukte eines Hydroxyalkylesters der Acryl- oder Methacrylsäure, beispielsweise von 2-Hydroxyethylacrylat oder 2-Hydroxypropylacrylat, an eine Polycarbonsäureanhydrid, wie beispielsweise Bernsteinsäure-, Glutarsäure-, Maleinsäure-, Hexahydrophthalsäure- oder Phthalsäureanhydrid. Ganz besonders bevorzugte Verbindungen A1) sind Acrylsäure oder Methacrylsäure.
In einer weiteren bevorzugten Klasse von Reaktionsprodukten aus A) und B) ist A) eine Verbindung A2), die wenigstens eine strahlungspolymerisierbare, ethylenisch ungesättigte Gruppe und wenigstens eine Epoxidgruppe aufweist, und B) ist eine Verbindung B2), die wenigstens eine photoinitiierende Benzophenon-, α-substituierte Acetophenon- oder Thioxanthongruppe und wenigstens eine Hydroxylgruppe aufweist, besonders bevorzugt eine Verbindung der Formeln VIIIA, VIIIB, VIIIC, IX, X, XI oder XII, wie weiter oben definiert.

Geeignete, bevorzugte und ganz besonders bevorzugte Verbindungen der Formeln VIIIA bis XII sind weiter oben beschrieben.

In dieser bevorzugten Gruppe ist A2) insbesondere ein Umsetzungsprodukt eine Epoxidharzes mit einem stöchiometrischen Unterschuss eine Verbindung enthaltend besagte ungesättigte Gruppe und wenigstens eine Hydroxyl- oder Carboxylgruppe.

Bei der ungesättigten Gruppe handelt es sich bevorzugt um eine Vinylgruppe, insbesondere eine Acrylgruppe.

Bevorzugte Verbindungen A2) sind Umsetzungsprodukte von einem Epoxidharz mit einem stöchiometrischen Unterschuss von Acrylsäure oder Methacrylsäure oder mit einem Addukt eines Hydroxyalkylesters von Acrylsäure oder Methacrylsäure, wie oben erwähnt, an ein Anhydrid einer Polycarbonsäure, wie oben erwähnt.

Von diesen bevorzugten Verbindungen werden die Umsetzungsprodukte von Epoxidharzen mit Acylsäure oder Methacrylsäure ganz besonders bevorzugt.

Ueblicherweise setzt man zur Herstellung dieser beiden Klassen von besonders bevorzugten Harzen ein Epoxidharz P) in beliebiger Reihenfolge oder gleichzeitig mit Q einer Acrylsäure oder Methacrylsäure oder einen Addukt eines Hydroxyalkylesters einer Acrylsäure oder Methacrylsäure an ein Polycarbonsäureanhydrid und mit einer Verbindung R) der Formel VIIIA, VIIIB, VIIIC, IX, X, XI oder XII, wie oben definiert, um. Die Reaktionen können in an sich bekannter Weise, wie bei Epoxid-Carbonsäure- oder Epoxid-Hydroxylreaktionen üblich, erfolgen.

In der Regel erhitzt man die Reaktanden in Gegenwart eines tertiären Amins oder eines Salzes davon oder eines quaternären Ammoniumsalzes als Katalysator.

Als Ausgangsmaterialien für die Herstellung strahlungspolymerisierbarer Harze geeignete Epoxidharze eignen sich beispielsweise Polyglycidylether von mehrwertigen Alkoholen, wie beispielsweise von 1,3-Propandiol, 1,4-Butandiol sowie von Polyoxyethylen- und Polyoxypropylendiolen oder -triolen; Polyglycidylether von mehrwertigen Phenolen, wie beispielsweise von Bis-(4-hydroxyphenyl)-methan, 2,2-Bis-(4-hydroxyphenyl)-propan oder halogensubstituierten Derivaten davon oder von phenolischen Novolaken, die sich von Phenolen, insbesondere von Phenol selbst, und einem Aldehyd, insbesondere von Formaldehyd, ableiten; Poly-(N-glycidyl)-derivate, umfassend solche von aromatischen Aminen, beispielsweise von Anilin, Bis-(4-aminophenyl)-methan oder Isocyanursäure oder von Hydantoinen, beispielsweise von 5,5-Dimethylhydantoin; Polyglycidylester von Polycarbonsäure, beispielsweise solche von aliphatischen Säuren, so wie von Bernsteinsäure, Adipinsäure und Maleinsäure, oder von cycloaliphatischen Säuren, wie beispielsweise solche von Tetrahydrophthalsäure, oder von aromatischen Säuren, wie beispielsweise von Phthalsäure; cycloaliphatische Epoxidharze, wie beispielsweise Vinylcylcohexendioxid, 3,4-Epoxycyclohexylmethyl-3,4-epoxycyclohexancarboxylat und Ethylenglykol-bis-(3,4-epoxycyclohexancarboxylat).

Bevorzugte Epoxidharze sind die Diglycidylether von Bisphenolen, insbesondere auf Basis von 2,2-Bis-(4-hydroxyphenyl)-propan, und vorverlängerte Harze, die erhältlich sind durch Umsetzung solcher Diglycidylether mit einem Bisphenol, insbesondere mit 2,2-Bis-(4-hydroxyphenyl)-propan oder mit einem Hydantoin, insbesondere mit 5,5-Dimethylhydantoin.

Für den Fall, dass die zwei bevorzugten Klassen von Reaktionsprodukten aus A) und B), wie oben beschrieben, fest sind, also für den Fall, dass diese sich beispielsweise ableiten von vorverlängerten Epoxidharzen, ist in der Regel keine weitere Reaktion mehr notwendig, um das Molekulargewicht zur erhöhen.

Für den Fall, dass diese Harze flüssig sind, werden sie weiter umgesetzt; die Reaktion erfolgt über die sekundären Hydroxylgruppen und die Umsetzung erfolgt vorzugsweise mit C) einem Diisocyanat, einer Verbindung, die zwei Acylhalogenidgruppen besitzt, oder besonders bevorzugt, mit einem Dianhydrid eine Polycarbonsäure, so dass feste Harze entstehen.

Geeignete Dianhydride leiten sich beispielsweise von Pyrromellithsäure, Benzophenon-3,3ʹ,4,4ʹ-tetracarbonsäure, Cyclopentan-1,2,4,5-tetracarbonsäure und, ganz besonders bevorzugt, von Ethylendiamintetraessigsäure ab.

Ethylendiamintetraessigsäuredianhydrid wird bevorzugt, weil damit Harze erhältlich sind, die sowohl salzbildende Aminogruppen als auch Säuregruppen enthalten; diese Gruppen können mit einer Säure oder Base neutralisiert werden und man erhält wahlweise kathodisch- oder anodisch-galvanisch abscheidbare Harze.

Eine dritte bevorzugte Gruppe von Umsetzungsprodukten von A) und B) sind Verbindungen, worin A) ein Glycidylacrylat oder Glycidylmethacylat A3) ist und B) ein Carboxylgruppen enthaltendes Harz B3) darstellt, das erhältlich ist durch Umsetzung eines Epoxidharzes mit einer Verbindung der Formeln VIIIA, VIIIB, VIIIC, IX, X, XI oder XII und anschliessender Umsetzung des entstandenen hydroxylgruppenhaltigen Produktes mit einem Dianhydrid einer Polycarbonsäure.

Geeignete und bevorzugte Epoxidharze und geeignete bevorzugte Verbindungen der Formeln VIIIA bis XII, die in dieser Modifikation eingesetzt werden können, sind bereits weiter oben beschrieben.

Von den Dianhydriden kann man hier die weiter oben als bevorzugt beschriebenen Verbindungen einsetzen, ganz besonders bevorzugt setzt man das Dianhydrid der Ethylendiaminotetraessigsäure ein; in dieser Ausführungsform dabei enthält B3) also salzbildende Gruppen, die entweder mit Säuren oder mit Basen neutralisiert werden können.

Weitere bevorzugte Umsetzungsprodukte von A) und B) sind diejenigen, worin A) eine Verbindung A4) ist, wobei es sich um eine Verbindung mit wenigstens einem strahlungspolymerisierbaren, ethylenisch ungesättigten Rest und einer Halocarbonyl-, Isocyanat- oder N-Methylolgruppe handelt, und worin B) ein Harz B4) ist, wobei es sich um eine Verbindung mit einem photoinitiierenden Benzophenon-, α-substituierten Acetophenon- oder Thioxanthonrest und im Mittel mehr als einer Hydroxylgruppe im Molekül handelt. Die ethylenisch ungesättigte Gruppe in A4) ist vorzugsweise eine Vinylgruppe, insbesondere eine Acrylgruppe.

Geeignete Verbindungen A4) sind Säurechloride, Isocyanatoalkylester und N-Methylolamide der Acrylsäure oder der Methacrylsäure oder der carboxylgruppenhaltigen Addukte von Hydroxyalkylestern der Acrylsäure oder der Methacrylsäure an Anhydride von Polycarbonsäuren, beispielsweise der weiter oben als bevorzugt beschriebenen Addukte.

Bevorzugte Verbindungen A4) sind beispielsweise Acryloylchlorid, Methacryloylchlorid, 2-Isocyanatoethylacrylat, 2-Isocyanatoethylmethacrylat, N-Methylolacrylamid und N-Methylolmethacrylamid.

Ganz besonders bevorzugte Verbindungen A4) sind 2-Isocyanatoethylacrylat und 2-Isocyanatoethylmethacrylat.

Geeignete Harze B4) sind Umsetzungsprodukte eines Epoxidharzes mit einer Verbindung der Formeln VIIIA, VIIIB, VIIIC, IX, X, XI und XII wie oben definiert.

Geeignete, bevorzugte und besonders bevorzugte Verbindungen der Formeln VIIIA bis XII und geeignete und bevorzugte Epoxidharze sind bereits weiter oben beschrieben.
Die sekundären Hydroxylgruppen, die durch die Umsetzung der Epoxidgruppen mit den reaktiven Gruppen in den Verbindungen der Formel VIIIA bis XII entstehen, und irgendwelche weitere Hydroxylgruppen, die im Ausgangsepoxidharze anwesend sein können, beispielsweise im Falle eines vorverlängerten Epoxidharzes, werden mit den Halocarbonyl-, Isocyanat- oder Methylolgruppen in A4) in an sich bekannter Weise umgesetzt. Für den Fall, dass das Epoxidharz mit einem stöchiometrischen Unterschuss an Verbindungen der Formeln VIIIA bis XII umgesetzt wird, können die verbliebenen Epoxidgruppen beispielsweise mit einem sekundären Amin, beispielsweise mit Diethanolamin, oder mit einer geeigneten Aminosäure umgesetzt werden; dies kann entweder vor oder nach der Reaktion mit A4) erfolgen, so dass entweder in B4) oder in das Reaktionsprodukt von A4) und B4) eine salzbildende Gruppe eingeführt wird.

Weitere bevorzugte Umsetzungsprodukte von A) und B) sind solche, die sich durch Umsetzung einer Verbindung A5), enthaltend wenigstens eine strahlungspolymerisierbare, ungesättigte Gruppe und im Mittel mehr als eine Hydroxylgruppe im Molkül, mit einer Verbindung B5), die ein Anhydrid der Benzophenontetracarbonsäure oder eine Mischung von Anhydriden enthaltend das Dianhydrid der Benzophenontetracarbonsäure, herstellen lassen.

Die Umsetzung zwichen A5) und B5) erfolgt unter an sich bekannten Bedingungen, vorzugsweise unter solchen Bedingungen, dass ein Produkt mit einem solchen Molekulargewicht entsteht, dass besagtes Produkt fest ist; gegebenenfalls anfallende flüssige Produkte können beispielsweise mit einem Epoxidharz weiter umgesetzt werden, so dass ein festes Produkt entsteht.

In A5) ist die ungesättigte Gruppe vorzugsweise eine Vinylgruppe, insbesondere eine Acrylgruppe.

Geeignete Produkte A5) umfassen Umsetzungsprodukte eines Epoxidharzes mit einer stöchiometrischen Menge von Acrylsäure oder Methacrylsäure oder mit einem carboxylgruppenhaltigen Addukt eines Hydroxyalkylesters der Acryl- oder Methacrylsäure an ein Anyhdrid einer Polycarbonsäure. Beispiele für solche Addukte sind weiter oben beschrieben.
Bevorzugte Verbindungen A5) sind Umsetzugsprodukte von Diglycidylethern von zweiwertigen Alkoholen oder Phenolen, insbesondere von Diglycidylethern von 2,2-Bis-(4-hydroxyphenyl)-propan oder von einem vorverlängerten Produkt dieser Diglycidylether mit 2,2-Bis-(4-hydroxyphenyl)-propan, mit Acrylsäure oder Methacrylsäure.

Das Dianhydrid B5) ist vorzugsweise das Dianhydrid der 3,3ʹ,4,4ʹ-Benzophenontetracarbonsäure oder ein Gemisch dieses Dianhydrids mit einem weiteren Dianhydrid, beispielsweise mit dem Dianhydrid der Pyrromellithsäure.

Ein ganz besonders bevorzugtes Dianhydrid B5) ist die Mischung des Dianhydrids der 3,3ʹ,4,4ʹ-Benzophenontetracarbonsäure mit dem Dianhydrid der Ethylendiamintetraessigsäure, so dass das Reaktionsprodukt von A5) und B5) salzbildende Gruppen enthält, die mit Säuren oder mit Basen neutralisiert werden können.

Weitere bevorzugte Umsetzungsprodukte von A) und B) leiten sich ab von der Reaktion von einer Verbindung A6) enthaltend wenigstens einen strahlungspolymerisierbaren, ungesättigten Rest und eine Hydroxylgruppe mit einer Verbindung B6), die ein Dianhydrid der Benzophenontetracarbonsäure ist oder ein Gemisch dieses Dianhydrids mit einem weiteren Dianhydrid ist, und der weiteren Umsetzung des Produktes aus A6) und B6) mit einem Epoxidharz, um das Molekulargewicht des entstandenen Harzes zu erhöhen.

In A6) ist die ungesättigte Gruppe vorzugsweise eine Vinylgruppe, insbesondere eine Acrylsäuregruppe.

Geeignete Verbindungen A6) umfassen Hydroxyalkylester der Acrylsäure oder der Methacrylsäure oder es handelt sich um carboxylgruppenhaltigen Addukte eines Hydroxalkylacrylats oder -methacrylats an ein Anhydrid einer Polycarbonsäure, beispielsweise um eines der weiter oben beschriebenen Addukte.

Bevorzugte Verbindungen A6) sind 2-Hydroxyethyl- oder 2-Hydroxypropylester der Acrylsäure oder der Methacrylsäure, insbesondere bevorzugt wird 2-Hydroxyethylmethacrylat.

Bei B6) handelt es sich vorzugsweise um das Dianhydrid der 3,3ʹ,4,4ʹ-Benzophenontetracarbonsäure.

Geeignete und bevorzugte Epoxidharze, die sich zur Umsetzung mit dem Reaktionsprodukt von A6) und B6) einsetzen lassen, wurden bereits weiter oben beschrieben.

Die Umsetzung mit dem Epoxidharz kann so durchgeführt werden, dass ein epoxy-terminiertes Produkt entsteht. Bei diesem können dann wenigstens einige der Epoxidgruppen mit einem sekundären Amin, beispielsweise mit Diethanolamin, oder mit einer Aminosäure, beispielsweise mit 3-, oder 4-Dimethylaminobenzoesäure, umgesetzt werden, um salzbildende Gruppen einzuführen.

Für den Fall, dass die Umsetzungsprodukte von A), B) und gegebenenfalls C) bereits salzbildende Gruppen enthalten, brauchen diese nicht weiter umgesetzt werden, um besagte Gruppen einzuführen.

In den meisten Fällen werden die Umsetzungsprodukte Hydroxylgruppen enthalten; diese können mit einem Carbonsäureanhydrid, beispielsweise mit Bernsteinsäure-, Glutarsäure-, Tetrahydrophthalsäure-, Hexahydrophthalsäure-, Maleinsäure- oder Phthalsäureanhydrid umgesetzt werden, um eine Carboxylgruppen einzuführen. Für den Fall, dass die Umsetzungsprodukte überschüssige Epoxidgruppen enthalten, können diese mit einem sekundären Amin, beispielsweise mit Diethanolamin, Diisopropanolamin, Diethylamin, Di-n-butylamin, Piperidin oder Morpholin, umgesetzt werden, um eine tertiäre Aminogruppe einzuführen. Weitere Reaktionen, die zur Einführung einer salzbildenden Gruppe verwendet werden können, sind die Michael Addition eines Teils der ungesättigten Gruppen mit einem sekundären Amin, beispielsweise mit den weiter oben für die Umsetzung mit den überschüssigen Epoxidgruppen aufgeführten Aminen. Das strahlungsempfindliche Harz enthaltend eine salzbildende Gruppe kann neutralisiert werden, zumindest teilweise, bevor es im Galvanisierbad gelöst oder dispergiert wird; dabei wird die salzbildende Gruppe zumindest teilweise ionisiert.

Vorzugsweise wird diese Neutralisierung durch Zugabe einer Säure oder einer Base zum Galvanisierbad durchgeführt, das das Harz gelöst oder dispergiert enthält.

Enthält das strahlungspolymerisierbare Harz eine basische, salzbildende Gruppe, so wird die galvanische Abscheidung gemäss Schritt i) vorzugsweise aus einer wässrigen Lösung oder Dispersion vorgenommen, in welcher das Harz zusammen mit einer Säure vorliegt, die zumindest einen Teil der basischen Gruppen neutralisiert.

Enthält das strahlungsempfindliche Harz saure, salzbildende Gruppen, so wird die galvanische Abscheidung gemäss Schritt i) vorzugsweise aus einer wässrigen Lösung oder Dispersion vorgenommen, worin besagtes Harz zusammen mit einer Base vorliegt, welche zumindest einen Teil der sauren Gruppen neutralisiert.

Enthält das strahlungsempfindliche Harz basische und saure Gruppen, so wird die galvanische Abscheidung gemäss Schritt i) vorzugsweise aus einer wässrigen Lösung oder Dispersion vorgenommen, worin besagtes Harz zusammen mit einer Säure und einer Base vorliegt.

Für die gemäss der obigen Beschreibung bevorzugten strahlungsempfindlichen Harze, die sich von einem Dianhydrid von Diaminotetraessigsäure ableiten, wird die Neutralisation mit einer Säure bevorzugt.

Das wässrige Medium kann ein wassermischbares, organisches Lösungsmittel enthalten, um die Auflösung oder die Dispergierung des strahlungsempfindlichen Harzes zu unterstützen.

Geeignete organische Lösungsmittel umfassen Ketone, wie beispielsweise Aceton, Methylethylketon und Methylisobutylketon; Alkohole, wie beispielsweise Ethanol, 2-Methoxyethanol, 2-Ethoxyethanol, 2-n-Butoxyethanol, Diethylenglycol-Monobutylether; sowie Ester, wie beispielsweise 2-Methoxypropylacetat und 2-Ethoxyethylacetat.

Das Galvanisierbad enthält in der Regel 2 bis 60 Gew.-% des strahlungsempfindlichen Harzes, bevorzugt 5 bis 20 Gew.-%.

Die Erfindung betrifft ferner eine Zusammensetzung, die sich zur Durchführung des oben definierten Verfahrens eignet; diese Zusammensetzung enthält eine wässrige Lösung oder Dispersion eines strahlungsempfindlichen Harzes mit salzbildenden Gruppen, wie oben definiert, zusammen mit einem Säure oder Base, welche zumindest einen Teil besagter salzbildender Gruppen neutralisiert.

Diese Zusammensetzung kann weitere übliche Zusätze enthalten, beispielsweise Farbstoffe, Pigmente, Füllstoffe, Weichmacher und Netzmittel.

Geeignete Säuren zur Durchführung der Neutralisation sind organische oder anorganische Säuren, so wie beispielsweise Essigsäure, Milchsäure, Trichloressigsäure, Methansulfonsäure, Glykolsäure, p-Toluolsulfonsäure, Salzsäure und Schwefelsäuren.

Geeignete Basen zur Durchführung der Neutralisation sind organische oder anorganische Basen, so wie beispielsweise Triethylamin, Triethanolamin, Pyridin, Morpholin, Natrium- oder Kaliumhydroxid, Natrium- oder Kaliumcarbonat oder Natrium- oder Kaliumethanolat.

Die galvanische Abscheidung des strahlungspolymerisierbaren Harzes kann mittels üblicher Abscheidungsverfahren für harzartige Materialien erfolgen.

In der Regel legt man Spannungen bis zu 200 V für bis zu 5 Minuten an. Die genauen Bedingungen für spezifische, strahlungspolymerisierbare Harze, Substrate und gewünschte Schichtdicken lassen sich vom Fachmann anhand von Standardmethoden ermitteln.

Das Substrat, auf dem das strahlungspolymerisierbare Harz abgeschieden wird, kann ein elektrisch leitfähiges Kunststoffmaterial sein, beispielsweise ein wärmegehärtetes Harz, in dem elektrisch leitfähige Teilchen verteilt sind, oder es handelt sich vorzugsweise um ein Metall, wie beispielsweise Kupfer oder Aluminium; dieses kann beispielsweise als festes Metallblech vorliegen oder als metallkaschiertes Laminat, das auch metallüberzogene durchgehende Bohrungen oder Verbindungen enthält.

Die Behandlung des abgeschiedenen Films mit einem vorbestimmten Muster von Strahlung kann mittels Belichtung durch eine bildtragende Vorlage erfolgen, die aus im wesentlichen undurchlässigen und durchlässigen Flächen besteht; die Belichtung kann auch durch einen computergesteuerten Laserstrahl erfolgen.

In der Regel verwendet man elektromagnetische Strahlung mit einer Wellenlänge von 200 bis 600 nm.

Geeignete Strahlungsquellen sind beispielsweise Kohlelichtbögen, Quecksilberdampflampen, Leuchtstoffröhren mit ultraviolett emittierenden Phosphoren, Argon- und Xenonglühentladungslampen, Wolframlampen und photographische Flutlichtlampen. Von diesen Strahlungsquellen sind insbesondere Quecksilberdampflampen und Metallhalogenidlampen besonders bevorzugt.

Die Belichtungszeit ist in der Regel abhängig von der Art des eingesetzten strahlungsempfindlichen Harzes und von weiteren Faktoren, wie die Dicke der galvanisch abgeschiedenen Schicht, der Art der Strahlungsquelle und deren Abstand vom Film. Die jeweilige Bestrahlungsdauer kann durch Routineexperimente ermittelt werden. Nach der Bestrahlung entfernt man diejenigen Anteile des Films, die nicht von der Strahlung getroffen wurden. Dazu entwickelt man den Film vorzugsweise mit einem wässrigen oder organischen Lösungsmittel oder mit einer Mischung dieser Lösungsmittel, wobei die belichteten und polymerisierten Flächenanteile zurückbleiben.

Geeignete wässrige Lösungsmittel umfassen Natron- oder Kalilauge oder wässrige Natrium- oder Kaliumcarbonatlösungen oder Dinatriumhydrogenphosphatlösungen; solche Entwicklungsmittel verwendet man im Zusammenhang mit strahlungspolymerisierbaren Harzen, die saure Gruppen enthalten.
Weitere geeignete wässrige Lösungsmittel umfassen wässrige Säuren, wie beispielsweise wässrige Essigsäure, Milchsäure, Glykolsäure oder p-Toluolsulfonsäure; solche Entwicklungsmittel verwendet man im Zusammenhang mit strahlungspolymerisierbaren Harzen, die basische Gruppen enthalten.

Geeignete organische Lösungsmittel umfassen Ketone, wie beispielsweise Aceton, Methylethylketon und Cyclohexanon; Alkohole, wie beispielsweise Ethanol, 2-Ethoxyethanol und 2-Butoxyethanol; Kohlenwasserstoffe, wie beispielsweise Toluol oder Xylol und Ether, wie beispielsweise Tetrahydrofuran oder Dioxan.

Weitere geeignete Lösungsmittel zur Anwendung als Entwickler sind Gemische von Wasser mit denjenigen der oben erwähnten organischen Lösungsmittel, die wassermischbar sind; ein Beispiel dafür ist eine Mischung aus Wasser und 2-n-Butoxyethanol.

Mit dem erfindungsgemäßen Verfahren lassen sich beispielsweise Druckplatten und gedruckte Schaltungen herstellen.

Falls es sich bei der Substratoberfläche um ein Metall handelt, kann diese nach Belichtung und Entwicklung geätzt werden, um entweder das Metall aus den nichtbelichteten Flächenanteilen zu entfernen, beispielsweise zur Herstellung einer gedruckten Schaltung, oder um die Tiefe und somit die Differenzierung der Abbildung zu vergrössern; dabei schützt der polymerisierte Film in den bestrahlten Flächenanteilen das darunter liegende Substrat vor einem Angriff des Aetzmittels.

Geeignete Aetzverfahren sind dem Fachmann bekannt, beispielsweise die Verwendung von Eisen(III)chlorid oder von Ammoniumperchloratlösungen auf Kupfersubstraten.

Der verbliebene Film kann anschliessend, falls gewünscht, mit einem stärkeren Lösungsmittel als dem bei der Entwicklung eingesetzten entfernt werden; man kann auch ein ähnliches Lösungsmittel wie bei der Entwicklung unter schärferen Bedingungen verwenden. Dabei wird die darunterliegende metallische Oberfläche freigelegt.

Eine weitere Behandlungsmöglichkeit nach dem Entwickeln betrifft das Ueberziehen eines metallischen Substrates mit weiterem Metall, wie beispielsweise mit Kupfer, Zinn, Blei oder Nickel. Danach wird der polymerisierte Film durch Behandlung mit einem Lösungsmittel, wie oben beschrieben, entfernt, und das freigelegte Metall wird dann weggeätzt, wie oben beschrieben.

Mit dem erfindungsgemässen Verfahren lassen sich insbesondere gedruckte Schaltungen mit verdeckten Durchgangsleitungen herstellen, beispielsweise Mehrschicht-Leiterplatten aus festen Laminaten, die durchgehende beschichtete Bohrungen aufweisen, welche beide Seiten der Schaltungen leitfähig miteinander verbinden.

Die folgenden Beispiele erläutern die Erfindung. Mengenangaben beziehen sich auf Gewichtsteile, wenn nichts anderes angegeben ist.

In den Beispielen werden die folgenden Harze verwendet:

### Harz I

Hierbei handelt es sich um einem Diglycidylether von 2,2-Bis-(4-hydroxyphenyl)-propan mit einem Epoxidwert von 5,2 Aequ./kg.

### Harz II

Hierbei handelt es sich um einem Diglycidylether von 2,2-Bis-(4-hydroxyphenyl)-propan mit einem Epoxidwert von 5,32 Aequ./kg.

### Harz III

100 g eine Epoxidharzes auf Basis von 2,2-Bis-(4-hydroxyphenyl)-propan mit einem Epoxidwert von 1,6 Aequ./kg werden mit 0,1 g 2,6-Di-tert.butyl-4-methylphenol bis zur Schmelze erwärmt und dann unter Rühren auf 130°C erhitzt.
Zu diesem Gemisch gibt man innerhalb von 30 Minuten ein Gemisch aus 10,7 g Acrylsäure, 0.05 g Chrom-III-trisoctanoat und 0,2 g 2,6-Di-tert.butyl-4-methylphenol. Nach beendeter Addition erhitzt man unter Rühren weitere zwei Stunden bei 130°C und lässt abkühlen. Das Produkt besitzt einen vernachlässigbaren Epoxidgehalt.

### Harz IV

100 g Bis-(4-glycidyloxyphenyl)-propan mit einem Epoxidgehalt von 5,1 Aequ./kg werden zusammen mit 0,1 g 2,6-Di-tert.butyl-4-methylphenol unter Rühren auf 100° erhitzt. Dazu gibt man innerhalb von eineinhalb Stunden ein Gemisch aus 19,1 g Acrylsäure, 0,05 g Chrom-III-trisoctanoat und 0,05 g 2,6-Di-tert.butyl-4-methylphenol. Nach beendeter Addition rührt man weitere sieben Stunden bei 100°C und lässt abkühlen. Das Produkt besitzt einen vernachlässigbaren Epoxidgehalt.

Beispiel 1: Man erhitzt eine Mischung aus 100 g Diglycidylether auf Basis von 2,2-Bis-(4-hydroxyphenyl)-propan mit einem Epoxidwert von 5,2 Aequ./kg (Harz I), 5,0 g 1-Benzoylcyclohexanol und 0,1 g Diethylamin-Hydrochlorid vier Stunden lang auf 120°C. Das erhaltene Reaktionsgemisch besitzt einen Epoxidwert von 4,77 Aequ./kg. Die Mischung wird auf 60°C heruntergekühlt und dazu gibt man innerhalb einer Stunde eine Mischung aus 43,0 g Methacrylsäure und 0,2 g 2,6-Di-tert.butyl-4-methylphenol. Das Gemisch wird dann weitere sechs Stunden bei 60°C gehalten und danach 16 Stunden auf 80°C erhitzt. Nach dieser Zeit ist der Epoxidgehalt auf 0,28 Aequ./kg gefallen. Anschliessend fügt man 5,0 g des Dianhydrids von Ethylendiamintetraessigsäure zu, erhitzt weitere zwei Stunden auf 120°C und kühlt dann auf Raumtemperatur ab.

Man erhält ein strahlungspolymerisierbares Harz enthaltend salzbildende Gruppen.
Man bereitet eine Elektrolytlösung aus 35 g des oben hergestellten Produktes, 50 g 2-n-Butoxyethanol, 1,07 g Milchsäure und 37,5 g Wasser. In diese Lösung werden ein kupferkaschiertes Laminat und ein Blech aus rostfreiem Stahl als Kathode bzw. Anode eingetaucht. Bei 50 V wird eine Minute lang ein elektrischer Strom durch diese Anordnung fliessen gelassen und ein Harzfilm schlägt sich auf dem Laminat nieder. Das beschichtete Laminat wird anschliessend aus der Lösung entfernt und fünf Minuten lang bei 90°C getrocknet. Man erhält einen galvanisch abgeschiedenen Film von drei bis sieben µm Dicke. Die Beschichtung ist klebfrei und fest. Die getrocknete Beschichtung wird mittels einer 5000 W Metallhalogenidlampe durch ein Negativ im Abstand von 75 cm zwei Minuten lang bestrahlt. Nach dem Entwickeln der bestrahlten Schicht in einer Mischung aus Wasser und 2-n-Butoxyethanol (Volumenverhältnis 9:1) erhält man eine deutliche Abbildung des Negativs.

Beispiel 2: 100 g Harz II, 5,4 g 1-Benzoylcyclohexanol und 0,1 Teile Diethylamin-Hydrochlorid werden sechs Stunden lang auf 120°C erhitzt. Man erhält ein Gemisch, dessen Epoxidgehalt 4,8 Aequ./kg beträgt. Dieses Gemisch wird auf 100°C heruntergekühlt und man gibt innerhalb von 45 Minuten eine Mischung aus 37,1 Teilen Acrylsäure, 0,24 Teilen 2,6-Di-tert.butyl-4-methylphenol und 0,1 Teilen Chrom-III-trisoctanoat zu. Man erhitzt weitere 6 1/4 Stunden bei 100°C und erhält eine Mischung mit einem Epoxidgehalt von 0,11 Aequ./kg.

Anschliesend gibt man 1,3 Teile des Dianhydrids von Ethylendiamintetraessigsäure zu und erhitzt weitere 3 1/2 Stunden auf 100°C. Nach dem Abkühlen erhält man einen harzartigen Feststoff.

Aus 20 Teilen dieses Produktes, 20 Teilen 2-n-Butoxyethanol, 1,28 Teilen Milchsäure und 13 Teilen Wasser stellt man eine Galvanisierlösung her. Wie in Beispiel 1 beschrieben scheidet man einen Harzfilm auf einem kupferkaschierten Laminat ab und trocknet 5 Minuten lang bei 90°C. Man erhält eine klebfreie, feste Beschichtung von 10 µm Dicke.

Die getrocknete Schicht wird mittels einer 5000 W Metallhalogenidlampe durch ein Negativ im Abstand von 75 cm 30 Sekunden lang bestrahlt.

Nach dem Entwickeln des bestrahlten Filmes mit einem Gemisch aus Wasser und 2-n-Butoxyethanol (Volumenverhältnis 9:1) erhält man eine deutliche negative Abbildung der Vorlage.

Beispiel 3: Man wiederholt Beispiel 2 unter Anlegen einer Spannung von 100 V (1 Minute) anstelle einer Spannung von 50 V (1 Minute).

Nach dem fünfminütigen Trocknen bei 90°C besitzt der galvanisch abgeschiedene Film eine Dicke von 10-15 µm.

Die getrocknete Beschichtung wird mittels einer 5000 W Metallhalogenidlampe durch ein Negativ im Abstand von 75 cm 20 Sekunden lang bestrahlt.

Nach dem Entwickeln der bestrahlten Schicht mit einem Gemisch aus Wasser und 2-n-Butoxyethanol (Volumerverhältnis 85:15) entsteht eine deutliche negative Abbildung der Vorlage.

Beispiel 4: Eine Mischung aus 100 Teilen Harz II, 5,4 Teilen 1-Benzoylcyclohexanol und 0,1 Teilen Diethylamin-Hydrochlorid wird eine Stunde lang auf 110°C erhitzt und danach zwei Stunden lang auf 125°C. Man erhält eine Mischung mit einem Epoxidgehalt von 4,9 Aequ./kg. Dieses Gemisch wird auf 100°C heruntergekühlt und man gibt innerhalb von 30 Minuten eine Mischung aus 37,1 Teilen Acrylsäure, 0,24 Teilen 2,6-Di-tert.butyl-4-methylphenol und 0,1 Teilen Chrom-III-trisoctanoat zu. Man setzt das Erhitzen auf 100°C 6 3/4 Stunden lang fort und erhält ein Reaktionsgemisch mit einem Epoxidgehalt von 0,11 Aequ./kg. Dann fügt man 28,6 Teile des Dianhydrids der Ethylendiamintetraessigsäure und 100 Teile 2-Methoxypropylacetat zu und erhitzt weitere drei Stunden auf 100°C. Zu 20 Teilen der erhaltenen Mischung gibt man 10 Teile 2-n-Butoxyethanol 2,0 Teile Milchsäure und 10,5 Teile Wasser und erhält eine Galvanisierlösung.

Gemäss dem Verfahren aus Beispiel 1 wird aus dieser Lösung eine harzartige Beschichtung auf einem kupferkaschierten Laminat galvanisch abgeschieden; dabei wird jedoch 1 Minute lang eine Spannung von 100 V angelegt (1 Minute) anstelle einer Spannung von 50 V (1 Minute). Die Beschichtung wird fünf Minuten lang bei 90°C getrocknet und man erhält einen klebfreien, festen Film von 10 µm Dicke.

Die getrocknete Beschichtung wird mittels einer 5000 W Metallhalogenidlampe 60 Sekunden lang aus einer Entfernung von 75 cm durch ein Negativ bestrahlt.

Nach dem Entwickeln des bestrahlten Films mit Butyldigol (Monobutylether von Diethylenglykol) entsteht ein klares negatives Abbild der Vorlage.

Beispiel 5: 100 Teile Harz III werden auf 120°C erhitzt. Dann fügt man 3 Teile Dianhydrid von Ethylendiamintetraessigsäure zu und rührt das Gemisch eine Stunde lang. Man gibt 4,8 Teile α-Methylolbenzoin zu und setzt das Erhitzen bei 120°C weitere zwei Stunden lang fort. Danach ist der Epoxidgehalt der Mischung auf Null gefallen. Man verdünnt die Mischung mit 107 Teilen 2-n-Butoxyethanol und kühlt auf 60°C ab. Bei dieser Temperatur fügt man 2,1 Teile Milchsäure zu und rührt 10 Minuten lang. Nach dem Abkühlen auf Raumtemperatur fügt man 40 Teile Wasser und 40 Teile Cyclohexanon zu und erhält somit eine Elektrolytlösung.

Gemäss dem Verfahren aus Beispiel 1 wird aus dieser Lösung ein harzartiger Film auf einem kupferkaschierten Laminat galvanisch abgeschieden und 10 Minuten bei 90°C getrocknet. Man erhält einen klebfreien, festen Film von einer Dicke von 2-5 µm.

Die getrocknete Beschichtung wird mittels einer 5000 W Metallhalogenidlampe durch ein Negativ im Abstand von 75 cm drei Minuten lang bestrahlt.

Nach dem Entwickeln durch Abbürsten mit einer Mischung aus Wasser und 2-n-Butoxyethanol (Volumenverhältnis 9:2) erhält man eine negative Abbildung der Vorlage.

Beispiel 6: Man wiederholt Beispiel 5 unter Anlegen einer Galvanisierspannung von 200 V (1 Minute) anstelle einer Galvanisierspannung von 50 V (1 Minute).

Der galvanisch abgeschiedene Film wird wie in Beispiel 5 behandelt und man erhält unter den gleichen Bedingungen eine negative Abbildung der Vorlage.

Beispiel 7: 100 Teile Harz IV, 10 eile Dianhydrid der Ethylendiamintetraessigsäure, 20 Teile Dianhydrid der Benzophenontetracarbonsäure, 50 Teile Cyclohexanon, 0,2 Teile Tetramethylammoniumchlorid und 0,3 Teile 2,6-Di-tert.butyl-4-methylphenol werden zusammen 11 3/4 Stunden auf 120°C erhitzt. Anschliessend fügt man 100 Teile Cyclohexanon und 0,5 Teile Benzyldimethylamin zu und setzt das Erhitzen bei 120°C weitere 2 1/2 Stunden fort.

Nach dieser Zeit lässt sich IR-spektroskopisch im Reaktionsgemisch kein Anhydrid mehr nachweisen.

28 Teile dieser Lösung werden mit 0,9 Teilen Milchsäure, 16 Teilen Wasser und 25 Teilen 2-n-Butoxyethanol zu einer Galvanisierlösung vermischt.

Nach dem Verfahren gemäss Beispiel 1 scheidet man einen harzartigen Film auf einem kupferkaschierten Laminat ab und trockent fünf Minuten lang bei 90°C. Man erhält einen klebfreien, festen Film von 2-4 µm Dicke.

Die getrocknete Beschichtung wird mittels einer 5000 W Metallhalogenidlampe durch ein Negativ im Abstand von 75 cm fünf Minuten lang bestrahlt.

Nach dem Entwickeln in einem Gemisch aus Wasser und 2-n-Butoxyethanol (Volumenverhältnis 8:2) erhält man ein negatives Abbild der Vorlage.

Beispiel 8: 100 Teile Harz II und 0,2 Teile Chrom-III-trisoctanoat werden auf 110°C erhitzt. Dazu fügt man innerhalb von 20 Minuten eine Lösung von 28,6 Teilen Essigsäure und 16,4 Teilen α,α-Dimethyl-α-N-morpholino-p-(2-hydroxyethylthio)-acetophenon. Man setzt das Erhitzen bei 110°C 8 3/4 Stunden lang fort, fügt dann weitere 2,8 Teile Essigsäure zu und erhitzt nochmals 2 1/2 Stunden lang. Danach erhält man eine Mischung mit einem vernachlässigbaren Epoxidgehalt.

Man erhitzt nun auf 120°C und fügt 14,5 Teile Dianhydrid von Ethylendiamintetraessigsäure zu. Bei dieser Temperatur rührt man weitere drei Stunden.

Nach dieser Zeit lässt sich im Gemisch kein Dianhydrid mehr mittels IR-Analyse nachweisen.

Man hält die Temperatur bei 120°C und gibt innerhalb von 30 Minuten 10,9 Teile Glycidylacrylat, 0,1 Teile Chrom-III-trisoctanoat und 0,3 Teile 2,6-Di-tert.butyl-4-methylphenol zu. Man hält weitere 3 1/2 Stunden bei dieser Temperatur. Danach ist der Epoxidgehalt der Mischung vernachlässigbar. Beim Abkühlen entsteht ein harzartiger Feststoff. 20 Teile dieses Produktes werden mit 10 Teilen 2-n-Butoxyethanol, 2 Teilen Milchsäure und 10,5 Teilen Wasser vermischt und man erhält eine Elektrolytlösung.

Nach dem Verfahren gemäss Beispiel 1 wird aus dieser Lösung ein harzartiger Film auf ein kupferkaschiertes Laminat galvanisch abgeschieden. Man legt allerdings 1 Minute lang eine Spannung von 100 V an anstelle von 50 V (1 Minute). Nach dem Trocknen bei 90°C (5 Minuten) erhält man eine klebfreie, feste Beschichtung von 10 µm Dicke.

Die getrocknete Beschichtung wird mittels einer 5000 W Metallhalogenidlampe durch ein Negativ im Abstand von 75 cm 1 Minute lang bestrahlt.
Nach dem Entwickeln des bestrahlten Films in Butyldigol erhält man eine gute Abbildung der Vorlage.

Beispiel 9: Man führt eine Mischung aus 50 Teilen Harz II, 5 Teilen α,α-Dimethyl-α-N-morpholino-p-(2-hydroxyethylthio)-acetophenon und 0,1 Teilen Tetramethylammoniumchlorid sieben Stunden lang bei 120°C. Danach beträgt der Epoxidgehalt der Mischung 4,4 Aequ./kg. Man kühlt auf 100°C herunter und gibt innerhalb von 30 Minuten eine Lösung von 17,3 Teilen Acrylsäure, 0,2 Teilen 2,6-Di-ter.butyl-4-methylphenol und 0.1 Teilen Chrom-III-trisoctanoat zu. Nachdem weitere 3 1/2 Stunden bei 100°C erhitzt wurde, ist der Epoxidgehalt auf 0,32 Aequ./kg gefallen. Nun gibt man 7,3 Teile Dianhydrid der Ethylendiamintetraessigsäure zu und erhitzt weitere 3 1/2 Stunden auf 100°C.

Nach dieser Zeit lässt sich IR-spektroskopisch kein Anhydrid in der Mischung mehr nachweisen. Bei Abkühlen bildet sich ein harzartiger Feststoff.

20 Teile dieses Produktes werden in 20 Teilen 2-n-Butoxyethanol, 1,5 Teilen Milchsäure und 16 Teilen Wasser gelöst und es entsteht eine Elektrolytlösung.

Gemäss dem Verfahren aus Beispiel 1 scheidet man galvanisch aus dieser Lösung eine harzartige Beschichtung auf ein kupferkaschiertes Laminat ab. Man galvanisiert allerdings 2 Minuten lang bei einer Spannung von 50 V anstelle 1 Minute bei 50 V. Nach fünfminütigem Trocknen bei 90°C erhält man einen klebfreien, festen Film von 6-8 µm Dicke. Die getrocknete Beschichtung wird mittels einer 5000 W Metallhalogenidlampe durch ein Negativ aus einer Entfernung von 75 cm 20 Sekunden lang bestrahlt.

Nach dem Entwickeln des bestrahlten Films in einem Gemisch aus Wasser und 2-n-Butoxyethanol (Volumenverhältnis 9:1) entsteht ein deutliches negatives Abbild der Vorlage.

## Patentansprüche

1. Verfahren zur Herstellung von Abbildungen auf Substraten mit einer elektrisch leitfähigen Oberfläche umfassend die Schritte
i) Aufbringen einer strahlungspolymerisierbaren Schicht auf besagte Oberfläche durch galvanisches Abscheiden aus einer Zusammensetzung enthaltend eine Lösung oder einer Dispersion eines festen, strahlungspolymerisierbaren Harzes in einem zur galvanischen Abscheidung geeigneten Medium, wobei besagtes Harz im Mittel pro Molekül mehr als eine strahlungspolymerisierbare, ethylenisch ungesättigte Gruppe, einen Photoinitiatorrest, der bei Bestrahlung die Polymerisation besagter strahlungspolymerisierbaren Gruppe initiiert, und eine salzbildende Gruppe, die zumindest teilweise in ionisierter Form vorliegt, enthält,
ii) Bestrahlen besagter Schicht mit einem vorbestimmten Muster aktinischer Strahlung, wobei die bestrahlten Teile der Schicht polymerisieren, und
iii) Entfernen der in Schritt ii) nicht der Strahlung ausgesetzten Teile der Schicht.

2. Verfahren gemäss Anspruch 1, worin die strahlungspolymerisierbaren Gruppen Acrylat- oder Methacrylatgruppe sind.

3. Verfahren gemäss Ansprüchen 1 oder 2, worin besagter Photoinitiatorrest ein Benzophenon-, Ketocoumarin-, Benzil-, Anthrachinon-, Phenanthrachinon, α-substituierter Acetophenon-, Acylphosphinoxid-, O-acylierter α-Oximinoketon-, Xanthon- oder Thioxanthonrest ist, wobei besagter Rest mit dem Polymergerüst durch eine oder mehrere Bindungen verknüpft ist.

4. Verfahren gemäss Anspruch 3, worin der photoinitiierende Rest ausgewählt wird aus der Gruppe bestehend aus
a) Benzophenonresten der Formeln IA, IB, IC und ID
-Ar¹-CO-Ar² (IA),
-Ar¹-CO-Ar¹- (IB),
-Ar¹-CO-Ar³〈 (IC),
〉Ar³-CO-Ar³〈 (ID),
b) α-substituierten Acetophenonresten der Formeln II, III, IV, V oder VI 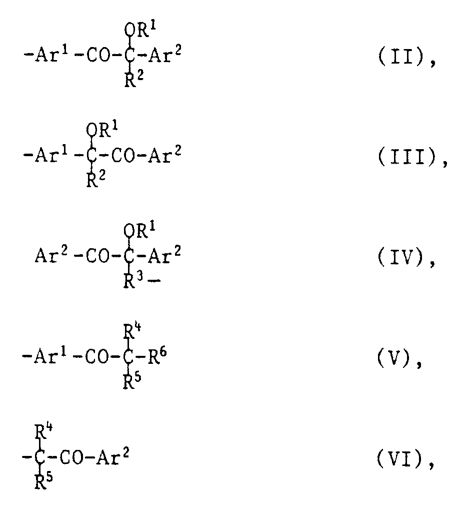 oder
c) Thioxanthonresten der Formel VII 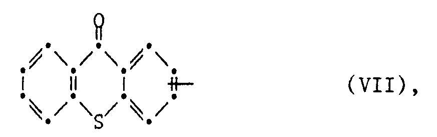 worin der jeweilige photoinitiierende Rest mit dem Restmolekül durch die freie(n) Bindung(en) verbunden ist,
Ar¹ eine Phenylengruppe ist, die gegebenenfalls mit ein bis drei Resten R⁷ substituiert ist,
Ar² eine Phenylgruppe ist, die gegebenenfalls mit ein bis drei Resten R⁷ substituiert ist,
Ar³ eine Benzoltriylgruppe ist, die gegebenenfalls mit ein bis drei Resten R⁷ substituiert ist,
R¹ Wasserstoff oder -CH₂R⁸ ist,
R² Wasserstoff , -O-CH₂R⁸ oder -CH₂-OR⁸ ist,
R³ C₁-C₂₀-Alkylen bedeutet, das durch ein oder mehrere Sauerstoffatome unterbrochen sein kann,
R⁴ und R⁵ unabhängig voneinander Wasserstoff oder eine einwertige aliphatische, cycloaliphatische oder araliphatische Gruppe sind, oder zusammen mit dem gemeinsamen Kohlenstoffatom eine Cycloalkylengruppe darstellen,
R⁶ eine Hydroxylgruppe, Aminogruppe oder eine alkylierte oder silylierte Hydroxyl- oder Aminogruppe ist,
R⁷ ein Halogenatom, C₁-C₂₀-Alkyl, C₁-C₂₀-Halogenalkyl, C₁-C₂₀-Alkoxy, C₆-C₁₂-Aryloxy, C₂-C₂₀-Acyloxy, C₂-C₂₀-Alkoxycarbonyl, C₇-C₁₃-Aracyloxy, C₂-C₄₀-Dialkylamino, C₁-C₂₀-Alkylthio, C₆-C₁₂-Arylthio oder Cyan bedeutet,
R⁸ Wasserstoff, Hydroxyl, C₁-C₈-Alkyl, C₁-C₄-Alkoxy, C₂-C₃-Alkenyl, C₇-C₉-Aralkyl, C₈-C₉-Aralkenyl oder -(CH₂)ₐR⁹ bedeutet,
a 1, 2 oder 3 ist und
R⁹ ein Halogenatom, Hydroxy, C₁-C₄-Alkoxy, C₁-C₄-Alkylthio, Phenoxy, Phenylthio, C₂-C₈-Acyloxy, C₇-C₁₂-Aracyloxy oder C₂-C₈-Alkoxycarbonyl ist.

5. Verfahren gemäss Anspruch 4, worin der photoinitiierende Rest die Formel ID besitzt, worin Ar³ ein unsubstituierter Benzoltriylrest ist, oder die Formel IV besitzt, worin R¹ ein Wasserstoffatom darstellt und R³ eine Methylengruppe ist, oder die Formel V besitzt, worin R⁴ und R⁵ jeweils eine Methylgruppe sind und R⁶ eine N-Morpholinogruppe ist, oder die Formel VI besitzt, worin R⁴ und R⁵ zusammen mit dem gemeinsamen C-Atom eine Cyclohexylengruppe darstellen.

6. Verfahren gemäss Ansprüche 1 bis 5, worin das photopolymerisierbare Harz erhältlich ist durch Umsetzung von
A) einer Verbindung mit wenigstens einer strahlungspolymerisierbaren Gruppe und wenigstens einer reaktiven funktionellen Gruppe X mit
B) einer Verbindung enthaltend besagten photoinitiierenden Rest und wenigstens eine Gruppe Y, die mit dem Rest X reagiert, oder durch Umsetzung eines Reaktionsproduktes von A) und B) mit wenigstens einer weiteren Verbindung C), um das Molekulargewicht zu erhöhen, wobei die salzbildende Gruppe in den Ausgangsprodukten A), B) oder
C) vorhanden sein kann oder in das Reaktionsprodukt von A) und B) oder in dessen Umsetzungsprodukt mit C) eingeführt werden kann.

7. Verfahren gemäss Anspruch 6, worin A) eine Verbindung ist, die wenigstens einen strahlungspolymerisierbaren, ethylenisch ungesättigten Rest aufweist, und B) eine Verbindung ist, die einen photoinitiierenden Benzophenon-, α-substituierten Acetophenon- oder Thioxanthonrest aufweist, wobei eine der Verbindungen A) oder B) eine Epoxidgruppe enthält und die andere eine Hydroxyl-, Carboxyl-, Carbonsäureanhydrid- oder Phosphonsäuregruppe enthält.

8. Verfahren gemäss Anspruch 7, worin A) sich ableitet von einer Verbindung A1) enthaltend wenigstens eine strahlungspolymerisierbare, ethylenisch ungesättigte Gruppe und wenigstens eine Hydroxyl-, Carboxyl- oder Phosphonsäuregruppe und B) sich ableitet von einer Verbindung B1) enthaltend einen photoinitiierenden Benzophenon-, α-substituierten Acetophenon- oder Thioxanthonrest und wenigstens eine Epoxidgruppe.

9. Verfahren gemäss Anspruch 8, worin B1) ein Umsetzungsprodukt eines Epoxidharzes mit weniger als der stöchiometrischen Menge einer Verbindung ist, welche besagten photoinitiierenden Rest und wenigstens eine Hydroxyl-, Carboxyl- oder Phosphonsäuregruppe aufweist.

10. Verfahren gemäss Anspruch 9, worin B1) ein Umsetzungsprodukt eines Epoxidharzes mit einem Benzophenon ausgewählt aus der Gruppe der Verbindungen der Formeln VIIIA, VIIIB oder VIIIC ist
Y¹-Ar¹-CO-Ar² (VIIIA),
Y¹-Ar¹-CO-Ar¹-Y¹ (VIIIB), 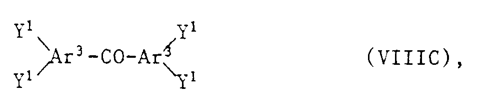
oder mit einem α-substituierten Acetophenon ausgewählt aus der Gruppe der Verbindungen der Formeln IX, X oder XI ist 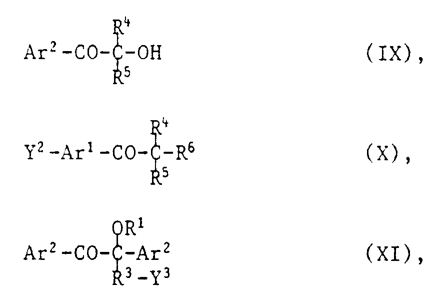 oder mit einem Thioxanton der Formel XII ist 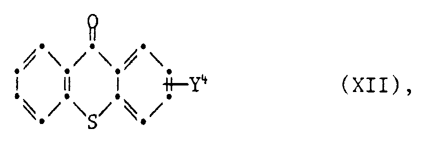 worin Ar¹, Ar², Ar³, R¹, R³, R⁴, R⁵ und R⁶ die in Anspruch 4 definierten Bedeutungen besitzen,
Y¹ -OH oder -COOH ist,
Y² eine der für Y¹ definierten Bedeutungen besitzt oder -S-CH₂-CH₂-OH ist,
Y³ eine der für Y¹ definierten Bedeutungen besitzt oder -P(=O)(O-CH₂-CH₃)(OH) ist,
Y⁴ eine der für Y¹ definierten Bedeutungen besitzt oder -O-CH₂-CH(OH)-CH₂-N(R¹⁴)R¹⁵ ist und R¹⁴ und R¹⁵ unabhängig voneinander C₁-C₂₀-Alkyl, das gegebenenfalls durch eine Hydroxylgruppe substituiert ist, bedeuten oder R¹⁴ und R¹⁵ zusammen mit dem gemeinsamen Stickstoffatom einen heterocyclischen Ring enthaltend drei bis fünf Kohlenstoffatome und gegebenenfalls ein Sauerstoffatom oder ein Schwefelatom oder ein zusätzliches Stickstoffatom, bilden.

11. Verfahren gemäss Anspruch 7, worin A) eine Verbindung A2) ist, die wenigstens eine strahlungspolymerisierbare, ethylenisch ungesättigte Gruppe und wenigstens eine Epoxidgruppe aufweist, und worin B) eine Verbindung B2) ist, die einen photoinitiierenden Benzophenon-, α-substituierten Acetophenon- oder Thioxanthonrest und wenigstens eine Hydroxyl-, Carbonsäure-, Carbonsäureanhydrid- oder Phosphonsäuregruppe aufweist.

12. Verfahren gemäss Anspruch 7, worin das strahlungspolymerisierbare Harz ein Reaktionsprodukt eines Epoxidharzes P) in beliebiger Reihenfolge oder gleichzeitig mit Q) Acrylsäure oder Methacrylsäure oder einem Addukt eines Hydroxyalkylesters einer Acrylsäure oder Methacrylsäure an ein Polycarbonsäureanhydrid und mit einer Verbindung R) der Formel VIIIA, VIIIB, VIIIC, IX, X, XI oder XII gemäss Anspruch 10 ist.

13. Verfahren gemäss Anspruch 7, worin die salzbildende Gruppe in das Reaktionsprodukt von A) und B) eingeführt wird, indem man dieses mit C) dem Dianhydrid einer Polycarbonsäure umsetzt.

14. Verfahren gemäss Anspruch 7, worin A) ein Glycidylacrylat oder Glycidylmethacrylat A3) ist und B) ein carboxylgruppenhaltiges Harz B3) darstellt, das erhältlich ist durch Umsetzung eines Epoxidharzes mit einer Verbindung der Formeln VIIIA, VIIIB, VIIIC, IX, X, XI oder XII gemäss Anspruch 10 und anschliessender Umsetzung der sekundären Hydroxylgruppen des entstandenen Produktes mit einem Dianhydrid einer Polycarbonsäure.

15. Verfahren gemäss Anspruch 6, worin A) eine Verbindung A5) ist, die wenigstens eine strahlungspolymerisierbare, ethylenisch ungesättigte Gruppe und im Mittel mehr als eine Hydroxylgruppe im Molekül enthält, und worin B) eine Verbindung B5) ist, die ein Dianhydrid der Benzophenontetracarbonsäure oder eine Mischung dieses Dianhydrids mit einem weiteren Anhydrid ist.

16. Verfahren gemäss Ansprüchen 1 bis 15, worin besagtes strahlungspolymerisierbares Harz eine basische, salzbildende Gruppe enthält und der Galvanisierschnitt i) mittels einer Lösung oder Dispersion besagten Harzes in einem wässrigen Medium zusammen mit einer Säure, die zumindest einen Teil der basischen Gruppen neutralisiert, ausgeführt wird; oder worin besagtes strahlungspolymerisierbares Harz eine saure, salzbildende Gruppe enthält und der Galvanisierschritt i) mittels einer Lösung oder Dispersion besagten Harzes in einem wässrigen Medium zusammen mit einer Base, die zumindest einen Teil der sauren Gruppen neutralisiert, ausgeführt wird.

17. Zusammensetzung, die sich zur Durchzuführung des Verfahrens gemäss Ansprüchen 1 bis 16 eignet, enthaltend eine wässrige Lösung oder Dispersion eines strahlungsempfindlichen Harzes mit salzbildenden Gruppen gemäss Anspruch 1 zusammen mit einer Säure oder Base, welche zumindestens einen Teil der besagten salzbildenden Gruppen neutralisiert.

18. Festes strahlungspolymerisierbares Harz mit salzbildenden Gruppen, das sich zur Durchführung des Verfahrens gemäss Anspruch 1 eignet und das erhältlich ist durch Umsetzung von A) einer Verbindung enthaltend wenigstens eine strahlungspolymerisierbare, ethylenisch ungesättigte Gruppe mit B) eine Verbindung enthaltend einen Benzophenon-, α-substituierten Acetophenon- oder Thioxanthonrest, wobei eine der Verbindungen A) oder B) eine Epoxidgruppe enthält und die andere eine Hydroxyl-, Carboxyl- oder Phosphonsäuregruppe enthält, wobei besagtes Umsetzungsprodukt gegebenenfalls mit einer weiteren Verbindung C) umgesetzt wird, um das Molekulargewicht zu erhöhen und wobei besagtes Umsetzungsprodukt salzbildende Gruppen besitzt, die über A), B) oder C) eingeführt werden oder die durch eine weitere Reaktion des Umsetzungsproduktes eingeführt werden.

## Claims

1. A process for the production of an image on substrates having an electrically conductive surface, comprising the steps of
(i) applying a radiation-polymerisable layer to the said surface by electrodeposition from a composition comprising a solution or a dispersion of a solid radiation-polymerisable resin in a medium suitable for electrodeposition, the said resin containing on average per molecule more than one radiation-polymerisable ethylenically unsaturated group, a photoinitiator radical which initiates polymerisation of the said radiation-polymerisable group on irradiation, and a salt-forming group which is present at least partially in ionised form,
(ii) irradiating the said layer with a predetermined pattern of actinic radiation, the irradiated parts of the layer polymerising, and
(iii) removing the parts of the layer not exposed to radiation in step (ii).

2. A process according to claim 1, in which the radiation-polymerisable groups are acrylate or methacrylate groups.

3. A process according to claims 1 or 2, in which the said photoinitiator radical is a benzophenone, ketocoumarin, benzil, anthraquinone, phenanthraquinone, α-substituted acetophenone, acylphosphine oxide, O-acylated α-oximinoketone, xanthone or thioxanthone radical, the said radical being connected to the polymer backbone via one or more linkages.

4. A process according to claim 3, in which the photoinitiating radical is selected from the group comprising
(a) benzophenone radicals of the formulae IA, IB, IC and ID
-Ar¹-CO-Ar² (IA),
-Ar¹-CO-Ar¹- (IB),
-Ar¹-CO-Ar³〈 (IC),
〉Ar³-CO-Ar³〈 (ID),
(b) α-substituted acetophenone radicals of the formulae II, III, IV, V or VI 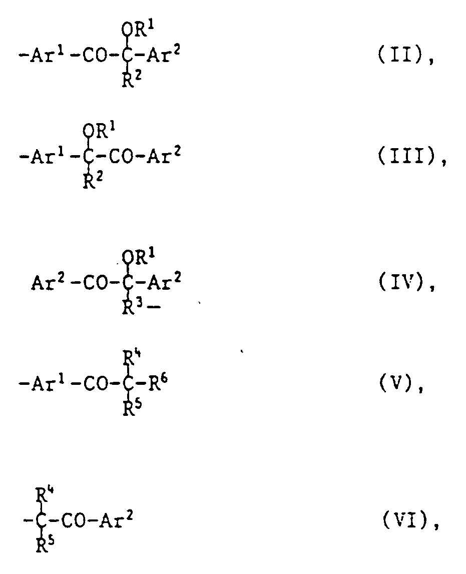 or
(c) thioxanthone radicals of the formula VII 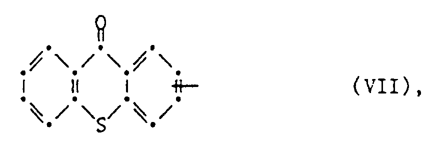 in which the respective photoinitiating radical is connected to the remainder of the molecule via the free bond(s),
Ar¹ is a phenylene group which may be substituted by one to three radicals R⁷,
Ar² is a phenyl group which may be substituted by one to three radicals R⁷,
Ar³ is a benzenetriyl group which may be substituted by one to three radicals R⁷,
R¹ is hydrogen or -CH₂R⁸,
R² denotes a hydrogen atom, -OCH₂R⁸ or -CH₂OR⁸,
R³ denotes a C₁-C₂₀alkylene which may be interrupted by one or more oxygen atoms,
R⁴ and R⁵ are, independently of one another, hydrogen or a monovalent aliphatic, cycloaliphatic or araliphatic group or, together with the joint carbon atom, represent a cycloalkylene group,
R⁶ is a hydroxyl group, amino or an alkylated or silylated hydroxyl or amino group,
R⁷ denotes a halogen atom, C₁-C₂₀alkyl, C₁-C₂₀haloalkyl, C₁-C₂₀alkoxy, C₆-C₁₂aryloxy, C₂-C₂₀acyloxy, C₂-C₂₀alkoxycarbonyl, C₇-C₁₃aracyloxy, C₂-C₄₀dialkylamino, C₁-C₂₀alkylthio, C₆-C₁₂arylthio or cyano,
R⁸ denotes hydrogen, hydroxyl, C₁-C₈alkyl, C₁-C₄alkoxy, C₂-C₃alkenyl, C₇-C₉aralkyl, C₈-C₉aralkenyl or - (CH₂)ₐR⁹,
a is 1, 2 or 3 and
R⁹ is a halogen atom, hydroxyl, C₁-C₄alkoxy, C₁-C₄alkylthio, phenoxy, phenylthio, C₂-C₈acyloxy, C₇-C₁₂aracyloxy or C₂-C₈alkoxycarbonyl.

5. A process according to claim 4, in which the photoinitiating radical has the formula ID in which Ar³ is an unsubstituted benzenetriyl radical, or has the formula IV in which R¹ represents a hydrogen atom and R³ is a methylene group, or has the formula V in which R⁴ and R⁵ are each a methyl group and R⁶ is an N-morpholino group, or has the formula VI in which R⁴ and R⁵, together with the joint carbon atom, represent a cyclohexylene group.

6. A process according to claims 1 to 5, in which the radiation-polymerisable resin is obtainable by reacting
A) a compound having at least one radiation-polymerisable group and at least one reactive functional group X with
B) a compound comprising the said photoinitiating radical and at least one group Y which reacts with the group X, or by reacting a reaction product of A) and B) with at least one further compound C), to increase the molecular weight, the salt-forming group possibly being present in the starting materials A), B) or C) or possibly being introduced into the reaction product of A) and B) or the reaction product thereof with C).

7. A process according to claim 6, in which A) is a compound having at least one radiation-polymerisable ethylenically unsaturated radical and B) is a compound having a photoinitiating benzophenone, α-substituted acetophenone or thioxanthone radical, one of the compounds A) and B) containing an epoxide group and the other containing a hydroxyl, carboxyl, carboxylic acid anhydride or phosphonic acid group.

8. A process according to claim 7, in which A) is derived from a compound A1) comprising at least one radiation-polymerisable ethylenically unsaturated group and at least one hydroxyl, carboxyl or phosphonic acid group and B) is derived from a compound B1) comprising a photoinitiating benzophenone, α-substituted acetophenone or thioxanthone radical and at least one epoxide group.

9. A process according to claim 8, in which B1) is a reaction product of an epoxy resin with less than the stoichiometric amount of a compound comprising the said photoinitiating radical and at least one hydroxyl, carboxyl or phosphonic acid group.

10. A process according to claim 9, in which B1) is a reaction product of an epoxy resin with a benzophenone selected from the group of compounds of the formulae VIIIA, VIIIB or VIIIC
Y¹-Ar¹-CO-Ar² (VIIIA),
Y¹-Ar¹-CO-Ar¹-Y¹ (VIIIB), 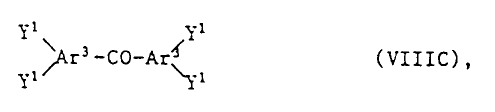
or with an α-substituted acetophenone selected from the group of compounds of the formulae IX, X or XI 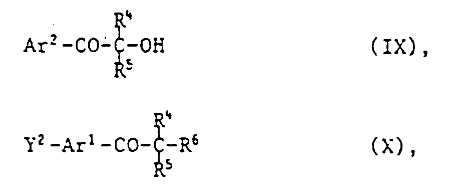 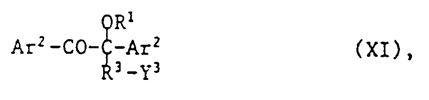 or with a thioxantone [sic] of the formula XII 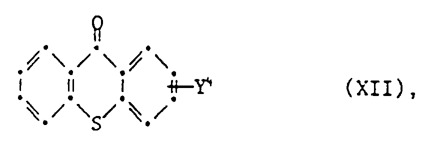 in which Ar¹, Ar², Ar³, R¹, R³, R⁴, R⁵ and R⁶ are as defined in claim 4,
Y¹ is -OH or -COOH,
Y² has one of the meanings defined for Y¹ or is -SCH₂CH₂OH,
Y³ has one of the meanings defined for Y¹ or is -P(=O)(OCH₂CH₃)OH,
Y⁴ has one of the meanings defined for Y¹ or is -OCH₂CH(OH)CH₂N(R¹⁴)R¹⁵, and
R¹⁴ and R¹⁵ independently of one another [lacuna] C₁-C₂₀alkyl, which may be substituted by a hydroxyl group, or R¹⁴ and R¹⁵, together with the joint nitrogen atom, form a heterocyclic ring containing three to five atoms and, optionally, one oxygen atom or sulfur atom or an additional nitrogen atom.

11. A process according to claim 7, in which A) is a compound A2) having at least one radiation-polymerisable ethylenically unsaturated group and at least one epoxide group and B) is a compound B2) having a photoinitiating benzophenone, α-substituted acetophenone or thioxanthone radical and at least one hydroxyl, carboxyl, carboxylic acid anhydride or phosphonic acid group.

12. A process according to claim 7, in which the radiation-polymereisable resin is a reaction product of an epoxy resin P) with in either order or simultaneously, Q) acrylic or methacrylic acid or an adduct of a hydroxyalkyl ester of an acrylic or methacrylic acid with a polycarboxylic acid anhydride and with a compound R) of the formula VIIIA, VIIIB, VIIIC, IX, X, XI or XII, as defined in claim 10.

13. A process according to claim 7, in which the salt-forming group is introduced into the reaction product of A) and B) by reacting it with C) a dianhydride of a polycarboxylic acid.

14. A process according to claim 7, in which A) is a glycidyl acrylate or glycidyl methacrylate A3) and B) is a carboxyl-containing resin B3) obtainable by reacting an epoxy resin with a compound of the formulae VIIIA, VIIIB, VIIIC, IX, X, XI or XII as defined in claim 10 and then reacting the secondary hydroxyl groups of the resulting product with a dianhydride of a polycarboxylic acid.

15. A process according to claim 6, in which A) is a compound A5) comprising at least one radiation-polymerisable unsaturated group and, on average, more than one hydroxyl group per molecule and in which B) is a compound B5), a benzophenonetetracarboxylic acid anhydride or a mixture of this dianhydride with another anhydride.

16. A process according to claims 1 to 15, in which the said radiation-polymerisable resin contains a basic salt-forming group and electrodeposition in step i) is effected by means of a solution or dispersion of the said resin in an aqueous medium together with an acid which neutralises at least some of the basic groups; or in which the said radiation-polymerisable resin contains an acidic salt-forming group and electodeposition in step i) is effected by means of a solution or dispersion of the said resin in an aqueous medium together with a base which neutralises at least some of the acidic groups.

17. A composition suitable for carrying out a process according to claims 1 to 16, comprising an aqueous solution or dispersion of a radiation-sensitive resin having salt-forming groups as defined in claim 1, together with an acid or base which neutralises at least some of the said salt-forming groups.

18. A solid radiation-polymerisable resin containing salt-forming groups, which is suitable for carrying out a process according to claim 1 and is obtainable by reacting A) a compound comprising at least one radiation-polymerisable ethylenically unsaturated group with B) a compound comprising a benzophenone, α-substituted acetophenone or thioxanthone radical, one of the compounds A) or B) containing an epoxide group and the other containing a hydroxyl, carboxyl or phosphonic acid group, the said reaction product optionally being reacted, to increase the molecular weight, with a further compound C) and the said reaction product having salt-forming groups introduced via A), B) or C) or introduced by a further reaction of the reaction product.

## Revendications

1. Procédé pour réaliser des images sur des substrats ayant une surface électroconductrice, procédé comprenant les étapes consistant :
(i) à appliquer une couche polymérisable sous l'effet d'un rayonnement sur ladite surface, par déposition galvanique à partir d'une composition contenant une solution ou une dispersion d'une résine solide, polymérisable sous l'effet d'un rayonnement, dans un milieu adapté à la déposition galvanique, ladite résine contenant en moyenne, par molécule, plus d'un groupe polymérisable sous l'effet d'un rayonnement et à insaturation éthylénique, un résidu d'un photo-amorceur, qui, sous l'effet d'un rayonnement, amorce la polymérisation dudit groupe polymérisable sous l'effet du rayonnement, et un groupe salifiable qui se présente au moins partiellement sous forme ionisée,
(ii) à exposer ladite couche à un modèle prédéfini de rayonnement actinique, ce qui provoque une polymérisation des zones exposées de la couche, et
(iii) à éliminer les zones de la couche qui, dans l'étape (ii), n'ont pas été exposées au rayonnement.

2. Procédé selon la revendication 1, dans lequel les groupes polymérisables sous l'effet d'un rayonnement sont des groupes acrylate ou méthacrylate.

3. Procédé selon la revendication 1 ou 2, dans lequel ledit résidu photo-amorceur est un résidu de benzophénone, de cétocoumarine, de benzile, d'anthraquinone, de phénanthraquinone, d'acétophénone α-substituée, d'oxyde d'acylphosphine, d'α-oximinocétone O-acylée, de xanthone ou de thioxanthone, ce résidu étant relié à la charpente polymère par une ou plusieurs liaisons.

4. Procédé selon la revendication 3, dans lequel le résidu photo-amorceur est choisi dans le groupe constitué par :
a) les résidus de benzophénone ayant les formues IA, IB, IC et ID
-Ar¹-CO-Ar¹- (IB),
-Ar¹-CO-Ar³〈 (IC),
〉Ar³-CO-Ar³〈 (ID),
b) les résidus d'acétophénone α-substitués de formules II, III, IV, V ou VI 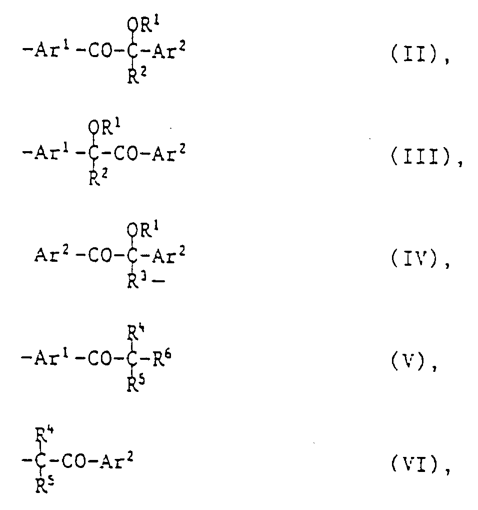 ou
c) les résidus de thioxanthone de formule VII 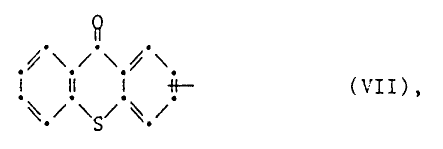 où chacun des résidus photo-amorceurs est lié au reste de la molécule par la ou les liaisons libres,
Ar¹ est un groupe phénylène, éventuellement substitué par un à trois radicaux R⁷,
Ar² est un groupe phényle, éventuellement substitué par un à trois radicaux R⁷,
Ar³ est un groupe benzènetriyle, éventuellement substitué par un à trois radicaux R⁷,
R¹ est un hydrogène ou -CH₂R⁸,
R² est un hydrogène -O-CH₂R⁸ ou -CH₂-OR⁸,
R³ est un radical alkylène en C₁ à C₂₀ pouvant être interrompu par un ou plusieurs atomes d'oxygène,
R⁴ et R⁵, indépendamment l'un de l'autre, sont chacun un hydrogène ou un groupe monovalent aliphatique, cycloaliphatique ou araliphatique, ou représentent ensemble avec l'atome de carbone commun un groupe cycloalkylène,
R⁶ est un groupe hydroxyle ou amino, ou un groupe hydroxyle ou amino alkylé ou silylé,
R⁷ est un atome d'halogène ou un radical alkyle en C₁ à C₂₀, halogénalkyle en C₁ à C₂₀, alcoxy en C₁ à C₂₀, aryloxy en C₆ à C₁₂, acyloxy en C₂ à C₂₀, (alcoxy en C₂ à C₂₀)carbonyle, aracyloxy en C₇ à C₁₃, dialkylamino en C₂ à C₄₀, alkylthio en C₁ à C₂₀, arylthio en C₆ à C₁₂ ou cyano,
R⁸ est un hydrogène ou un radical hydroxyle, alkyle en C₁ à C₈, alcoxy en C₁ à C₄, alcényle en C₂ à C₃, aralkyle en C₇ à C₉, aralcényle en C₈ à C₉ ou -(CH₂)ₐR⁹,
a vaut 1, 2 ou 3, et
R⁹ est un atome d'halogène ou un radical hydroxyle, alcoxy en C₁ à C₄, alkylthio en C₁ à C₄, phénoxy, phénylthio, acyloxy en C₂ à C₈, aracyloxy en C₇ à C₁₂ ou (alcoxy en C₂ à C₈)carbonyle.

5. Procédé selon la revendication 4, dans lequel le résidu photo-amorceur a la formule ID dans laquelle Ar³ est un radical benzènetriyle non-substitué, ou encore a la formule IV, dans laquelle R¹ est un atome d'hydrogène et R³ est un groupe méthylène, ou encore a la formule V, dans laquelle R⁴ et R⁵ sont chacun un groupe méthyle et R⁶ est un groupe N-morpholino, ou encore a la formule VI, dans laquelle R⁴ et R⁵ forment ensemble avec l'atome de carbone commun un groupe cyclohexylène.

6. Procédé selon les revendications 1 à 5, dans lequel la résine photopolymérisable peut être obtenue par la réaction de
A) un composé comportant au moins un groupe polymérisable sous l'effet d'un rayonnement et au moins un groupe fonctionnel réactif X, avec B) un composé contenant ledit résidu photo-amorceur et au moins un groupe Y qui réagit avec le résidu X, ou encore par réaction d'un produit de la réaction de A) et B) avec au moins un autre composé C), pour augmenter la masse moléculaire, auquel cas, le groupe salifiable peut être présent dans les produits de départ A), B) ou C), ou encore peut être incorporé dans le produit de la réaction de A) et de B) ou dans son produit de réaction avec C).

7. Procédé selon la revendication 6, dans lequel A) est un composé comportant au moins un résidu polymérisable sous l'effet d'un rayonnement et à insaturation éthylénique, et B) est un composé comportant un résidu photo-amorceur de benzophénone, d'acétophénone α-substituée ou de thioxanthone, l'un des composés A) ou B) contenant un groupe époxyde et l'autre contenant un groupe hydroxyle, carboxyle, anhydride d'acide carboxylique ou acide phosphonique.

8. Procédé selon la revendication 7, dans lequel A) dérive d'un composé A1) contenant au moins un groupe polymérisable sous l'effet d'un rayonnement et à insaturation éthylénique, et au moins un groupe hydroxyle, carboxyle ou acide phosphonique, et B) dérive d'un composé B1) contenant un résidu photo-amorceur de benzophénone, d'acétophénone α-substituée ou de thioxanthone et au moins un groupe époxyde.

9. Procédé selon la revendication 8, dans lequel B1) est un produit de la réaction d'une résine époxyde avec une quantité inférieure à la quantité stoechiométrique d'un composé comportant ledit résidu photo-amorceur et au moins un groupe hydroxyle, carboxyle ou acide phosphonique.

10. Procédé selon la revendication 9, dans lequel B1) est un produit de la réaction d'une résine époxyde avec une benzophénone choisie dans le groupe des composés de formules VIIIA, VIIIB ou VIIIC :
Y¹-Ar¹-CO-Ar² (VIIIA),
Y¹-Ar¹-CO-Ar¹-Y¹ (VIIIB), 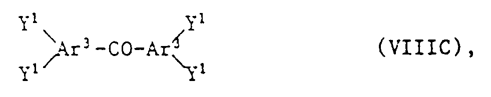
ou avec une acétophénone α-substituée choisie dans le groupe des composés de formules IX, X ou XI 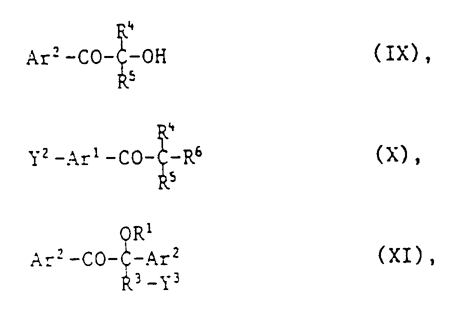 ou avec une thioxanthone de formule XII 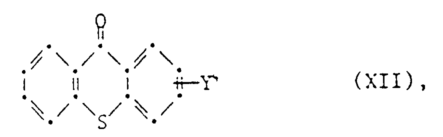 où Ar¹, Ar², Ar³, R¹, R³, R⁴, R⁵ et R⁶ ont les significations données dans la revendication 4,
Y¹ est -OH ou -COOH,
Y² a l'une des significations données pour Y¹, ou représente -S-CH₂-CH₂-OH,
Y³ a l'une des significations données pour Y¹, ou représente -P(=O)(O-CH₂-CH₃)(OH),
Y⁴ a l'une des significations données pour Y¹, ou représente -O-CH₂-CH(OH)-CH₂-N(R¹⁴)R¹⁵, et R¹⁴ et R¹⁵,
indépendamment l'un de l'autre, sont chacun un radical alkyle en C₁ à C₂₀, éventuellement substitué par un groupe hydroxyle, ou encore R¹⁴ et R¹⁵, ensemble avec l'atome d'azote commun, forment un noyau hétérocyclique contenant 3 à 5 atomes de carbone et éventuellement un atome d'oxygène ou un atome de soufre ou un atome d'azote supplémentaire.

11. Procédé selon la revendication 7, dans lequel A) est un composé A2) comportant au moins un groupe polymérisable sous l'effet d'un rayonnement, à insaturation éthylénique et au moins un groupe époxyde, et dans lequel B) est un composé B2) qui comporte un résidu photo-amorceur de benzophénone, d'acétophénone α-substituée ou de thioxanthone et au moins un groupe hydroxyle, acide carboxylique, anhydride d'acide carboxylique ou acide phosphonique.

12. Procédé selon la revendication 7, dans lequel la résine polymérisable sous l'effet d'un rayonnement est un produit de la réaction d'une résine époxyde P), dans un ordre quelconque ou simultanément, avec Q) un acide acrylique ou un acide méthacrylique ou un produit d'addition d'un ester hydroxyalkylique d'un acide acrylique ou d'un acide méthacrylique sur un anhydride d'acide polycarboxylique et avec un composé R) de formule VIIIA, VIIIB, VIIIC, IX, X, XI ou XII selon la revendication 10.

13. Procédé selon la revendication 7, dans lequel le groupe salifiable est introduit dans le produit de la réaction de A) et de B) par réaction de ce dernier avec C) le dianhydride d'un acide polycarboxylique.

14. Procédé selon la revendication 7, dans lequel A) est un acrylate de glycidyle ou un méthacrylate de glycidyle A3), et B) est une résine carboxylée B3), que l'on peut obtenir par la réaction d'une résine époxyde avec un composé de formules VIIIA, VIIIB, VIIIC, IX, X, XI ou XII selon la revendication 10, suivie d'une réaction des groupes hydroxyle secondaires du produit obtenu, avec un dianhydride d'un acide polycarboxylique.

15. Procédé selon la revendication 6, dans lequel A) est un composé A5), qui contient au moins un groupe polymérisable sous l'effet d'un rayonnement, à insaturation éthylénique et en moyenne plus d'un groupe hydroxyle dans sa molécule et dans lequel B) est un composé B5) qui est un dianhydride de l'acide benzophénone tétracarboxylique ou un mélange de ce dianhydride avec un autre dianhydride.

16. Procédé selon les revendications 1 à 15, dans lequel ladite résine polymérisable sous l'effet d'un rayonnement, contient un groupe salifiable basique, et l'étape de galvanoplastie i) est mise en oeuvre avec une solution ou une dispersion de cette résine dans un milieu aqueux, ensemble avec un acide qui neutralise au moins une partie des groupes basiques ; ou dans lequel, ladite résine polymérisable sous l'effet d'un rayonnement contient un groupe salifiable acide, et l'étape de galvanoplastie i) est mise en oeuvre au moyen d'une solution ou une dispersion de la résine dans un milieu aqueux, ensemble avec une base qui neutralise au moins une partie des groupes acides.

17. Composition convenant à la mise en oeuvre du procédé selon les revendications 1 à 16, qui contient une solution ou une dispersion aqueuse d'une résine sensible aux rayonnements, comportant des groupes salifiables selon la revendication 1, ensemble avec un acide ou une base qui neutralise au moins une partie desdits groupes salifiables.

18. Résine solide polymérisable sous l'effet d'un rayonnement, comportant des groupes salifiables, qui convient à la mise en oeuvre du procédé selon la revendication 1 et que l'on peut obtenir par la réaction de A) un composé contenant au moins un groupe polymérisable sous l'effet d'un rayonnement et à insaturation éthylénique avec B) un composé contenant un résidu de benzophénone, d'acétophénone α-substituée ou de thioxanthone, l'un des composés A) ou B) contenant un groupe époxyde et l'autre contenant un groupe hydroxyle, carboxyle ou acide phosphonique, ledit produit de réaction étant éventuellement mis à réagir avec un autre composé C) pour augmenter la masse moléculaire et ce produit de réaction possédant des groupes salifiables qui peuvent être introduits par l'intermédiaire de A), B) ou C) ou qui sont introduits par une autre réaction du produit de la réaction.
